# EUROPÄISCHE PATENTSCHRIFT

(11) **EP 4 551 533 B1**
(45) Veröffentlichungstag und Bekanntmachung des Hinweises auf die Patenterteilung: **29.04.2026**
(21) Anmeldenummer: 23738499.5
(22) Anmeldetag: 04.07.2023
(51) Int. Cl.: C03B 19/06, C03C 3/06, C03C 8/02

(54) **VERFAHREN ZUR HERSTELLUNG EINES GRUNDKÖRPERS EINES OPTISCHEN ELEMENTES FÜR DIE HALBLEITERLITHOGRAFIE UND GRUNDKÖRPER FÜR EIN OPTISCHES ELEMENT**
METHOD FOR PRODUCING A PREFORM OF AN OPTICAL ELEMENT FOR SEMICONDUCTOR LITHOGRAPHY, AND PREFORM FOR OPTICAL ELEMENT
PROCÉDÉ DE PRODUCTION D'UNE ÉBAUCHE D'UN ÉLÉMENT OPTIQUE POUR LITHOGRAPHIE À SEMI-CONDUCTEUR ET ÉBAUCHE POUR UN ÉLÉMENT OPTIQUE

(30) Priorität: 05.07.2022 DE 102022116694; 05.07.2022 DE 102022116695; 09.08.2022 DE 102022208286
(43) Veröffentlichungstag der Anmeldung: 14.05.2025
(73) Patentinhaber: Carl Zeiss SMT GmbH, 73447 Oberkochen (DE)
(72) Erfinder: SCHWEIGERT, Eduard, 89428 Syrgenstein (DE); FELDMANN, Heiko, 73430 Aalen (DE); EVA, Eric, 73434 Aalen (DE); DITTRICH, Johannes, 73547 Lorch (DE)
(74) Vertreter: Raunecker, Klaus Peter
(86) Internationale Anmeldenummer: PCT/EP2023/068297
(87) Internationale Veröffentlichungsnummer: WO 2024/008676

(56) Entgegenhaltungen:
- WO-A1-2022/053632
- WO-A1-2022/200627
- US-A1- 2010 234 205
- US-A1- 2012 107 589
- US-A1- 2020 039 868

## Beschreibung

Die vorliegende Anmeldung nimmt die Prioritäten der nachfolgend aufgeführten deutschen Patentanmeldungen in Anspruch:
DE 10 2022 208 286.9, eingereicht am 9. August 2022
DE 10 2022 116 694.5, eingereicht am 5. Juli 2022
DE 10 2022 116 695.3, eingereicht am 5. Juli 2022

Die Erfindung betrifft ein Verfahren zur Herstellung eines Grundkörpers für ein optisches Element für die Halbleiterlithografie, nutzbar für Projektionsbelichtungsanlagen, und einen Grundkörper.

Projektionsbelichtungsanlagen für die Halbleiterlithografie zeigen im Hinblick auf ihre Abbildungsqualität ein stark temperaturabhängiges Verhalten. Sowohl nicht unmittelbar an der optischen Abbildung beteiligte Elemente, wie beispielsweise Fassungen und Halter oder Gehäuseteile als auch optische Elemente selbst, wie beispielsweise Linsen oder, im Fall der EUV-Lithografie, Spiegel, verändern bei Erwärmung oder Abkühlung ihre Ausdehnung beziehungsweise ihre Oberflächenform, was sich unmittelbar in der Qualität der mit dem System vorgenommenen Abbildung einer Lithografiemaske, zum Beispiel einer Phasenmaske, eines sogenannten Retikels, auf ein Halbleitersubstrat, einen sogenannten Wafer, niederschlägt.

Die Erwärmung der einzelnen Komponenten der Anlage im Betrieb rührt dabei von der Absorption eines Teiles derjenigen Strahlung her, welche zur Abbildung des Retikels auf den Wafer verwendet wird und auch als Nutzstrahlung bezeichnet wird. Diese Strahlung wird von einer im Folgenden als Nutzlichtquelle bezeichneten Lichtquelle erzeugt. Im Fall der EUV-Lithografie handelt es sich bei der Nutzlichtquelle um eine vergleichsweise aufwendig ausgeführte Plasmaquelle, bei welcher mittels Laserbestrahlung von Zinnpartikeln ein in den gewünschten kurzwelligen Frequenzbereichen elektromagnetische Strahlung emittierendes Plasma erzeugt wird.

Üblicherweise sind Projektionsbelichtungsanlagen auf einen stationären Zustand während des Betriebes ausgelegt, das heißt auf einen Zustand, in welchem keine wesentlichen Änderungen der Temperatur von Anlagenkomponenten über der Zeit zu erwarten sind. Diese Temperatur kann für unterschiedliche optische Elemente, abhängig von der Anordnung im optischen System, unterschiedlich sein. Zur Minimierung der weiter oben beschriebenen Deformation und zeitlichen Änderung der optischen Elemente, insbesondere von Spiegeln, wird für den Grundkörper, insbesondere von Spiegeln, ein Material mit einem geringen Wärmeausdehnungskoeffizienten verwendet. So kann beispielsweise durch Zufügen von Titanoxid der Wärmeausdehnungskoeffizient eines Quarzglases derart eingestellt werden, dass dieser für eine bestimmte Temperatur, der sogenannten Nulldurchgangstemperatur, 0 beträgt. Der Wärmeausdehnungskoeffizient selbst ist dabei von der Temperatur abhängig, wobei dieser mit steigender Temperatur ansteigt, also bei Temperaturen unter der Nulldurchgangstemperatur negativ ist und bei Temperaturen oberhalb der Nulldurchgangstemperatur positiv ist.

Die Grundkörper für die einzelnen Spiegel werden in der Regel derart eingestellt, dass die Nulldurchgangstemperatur der im Betrieb konstanten Temperatur entspricht. Weiterhin wird versucht, die Steigung des Wärmeausdehnungskoeffizienten so flach wie möglich auszubilden, um die Auswirkung von Abweichungen von der Nulldurchgangstemperatur auf die Oberflächenform der Spiegel so gering wie möglich zu halten.

Weiterhin ist es durch die von Generation zu Generation steigende Leistung der Nutzlichtquellen notwendig, zumindest einzelne Spiegel durch im Grundkörper ausgebildete Fluidkanäle zu temperieren. Aus dem Stand der Technik sind Verfahren zur Herstellung von Grundkörpern mit integrierten Fluidkanälen bekannt, die aber den Nachteil haben, dass sie nicht für Materialien mit einer vorbestimmten Nulldurchgangstemperatur und einer geringen Steigung des Wärmeausdehnungskoeffizienten geeignet sind oder nur sehr aufwendig umzusetzen sind.

US2020039868 A1 offenbart ein Verfahren zur Herstellung eines optischen Elements aus einem Materialgemisch, welches Quarzglaspulver und einen organischen Binder enthält. Das Materialgemisch wird ausgehärtet, nach Bedarf durch mechanische Bearbeitung umgeformt und dann gebrannt und gesintert. Die Formung des Elements kann kann durch 3D-Druck erfolgen.

US2010234205 A1 lehrt ein TiO2-haltiges Quartzglas mit geringer Wärmedehnung. US2012107589 A1, WO2022053632 A1 und WO2022200627 A1 offenbaren die Herstellung von Quarzglas durch die thermische Zersetzung eines Gemisches aus SiO2-Glas-Nanopartikeln und einem organischen Polymer.

Aufgabe der vorliegenden Erfindung ist es, ein Verfahren anzugeben, welches die die aus dem Stand der Technik bekannten Nachteile beseitigt. Eine weitere Aufgabe der Erfindung ist es, einen verbesserten Grundkörpe anzugeben.

Diese Aufgabe wird gelöst durch das Verfahren in Anspruch 1 und durch den Grundkörper gemäß Anspruch 12. Die Unteransprüche betreffen vorteilhafte Weiterbildungen und Varianten der Erfindung.

Ein Verfahren zur Herstellung eines Grundkörpers eines optischen Elementes für die Halbleiterlithografie nicht gemäß der Erfindung umfasst folgende Schritte
- erstens die Herstellung eines Materialgemisches, welches mindestens zwei Materialkomponenten umfasst.
- zweitens die Herstellung eines Zwischenkörpers aus dem Materialgemisch,
- wobei das Materialgemisch mindestens eine erste Materialkomponente aus dem Material des späteren Grundkörpers umfasst
- und wobei das Materialgemisch eine zweite Materialkomponente umfasst, welche zur mechanischen Stabilisierung des Zwischenkörpers dient.
- drittens die Herstellung des Grundkörpers aus dem Zwischenkörper durch temporäres Erhitzen und mindestens teilweiser Entfernung der zweiten Materialkomponente.

In einer Ausführungsform des Verfahrens kann die mindestens eine erste Materialkomponente ein Quarzglaspulver, insbesondere ein mit Titanoxid dotiertes Quarzglaspulver umfassen; die zweite Materialkomponente kann mindestens ein Polymer umfassen. Die erste Materialkomponente kann auch mehrere unterschiedliche

Das Titanoxid bewirkt eine Reduzierung des Wärmeausdehnungskoeffizienten des ersten Materials und damit des Materialgemisches, welcher im Idealfall bei der Arbeitstemperatur des optischen Elementes, also der sich im Betrieb ausbildenden mittleren Temperatur, Null betragen kann. Die Temperatur, bei welcher der temperaturabhängige Wärmeausdehnungskoeffizient Null ist, wird auch als Nulldurchgangstemperatur bezeichnet. Zur Beeinflussung der Nulldurchgangstemperatur und der Steigung des Wärmeausdehnungskoeffizienten bei sich ändernder Temperatur können verschiedene Maßnahmen angewendet werden. Dabei hängt die Höhe des Wärmeausdehnungskoeffizienten zum Großteil vom prozentualen Anteil von Titanoxid in dem überwiegend Siliziumoxid aufweisenden Material ab, wobei mit steigendem Titanoxid-Gehalt der Wärmeausdehnungskoeffizient des Materialgemisches, also des Grundkörpers, sinkt, also eine Kurve des Wärmeausdehnungskoeffizienten über der Temperatur entlang der y-Achse nach unten verschoben wird. Dadurch wird gleichzeitig die Nulldurchgangstemperatur des Materialgemischs zu einer höheren Temperatur hin verschoben. Tempern des Grundkörpers bei einer Temperatur zwischen 900 °C und 1200 °C kann einerseits die Kurve des Wärmeausdehnungskoeffizienten in positive y-Richtung, also nach oben, verschieben, wodurch die Nulldurchgangstemperatur sinkt, und kann andererseits die Steigung der Kurve vorteilhaft reduzieren, so dass sich um die Nulldurchgangstemperatur herum die Änderung des Wärmeausdehnungskoeffizienten bei Temperaturänderungen verringert.

Das Pulver kann durch Zermahlen eines Ausgangsmaterials mit den vorbestimmten physikalischen Eigenschaften des Grundkörpers hergestellt werden oder kann derart ausgebildet sein, dass es nach dem erfindungsgemäßen Herstellungsverfahren den vorbestimmten physikalischen Eigenschaften des Grundkörpers entspricht.

Weiterhin kann ein Werkzeug zum Zermahlen des Ausgangsmaterials aus dem Material der ersten Materialkomponente ausgebildet sein. Dies hat den Vorteil, dass die erste Materialkomponente nicht durch Abrieb des Werkzeugs durch andere Stoffe, welche Auswirkungen auf die physikalischen Eigenschaften des Grundkörpers haben, verunreinigt werden kann.

Alternativ kann das Ausgangsmaterial berührungslos, wie beispielsweise durch ein Ultraschallverfahren, pulverisiert werden.

Das Pulver kann in einem Soot-Verfahren hergestellt werden.

Weiterhin kann ein Titanoxid-Gehalt im zermahlenen oder berührungslos hergestellten Pulver bei einer Probe von 1g weniger als 5%, bevorzugt weniger als 0,5%, besonders bevorzugt kleiner als 0,05% von einem mittleren Titanoxid-Gehalt des Grundkörpers abweichen. Dies kann beispielsweise im Vergleich zu herkömmlicher Direktabscheidung oder Sootabscheidung durch eine gute Durchmischung des Pulvers und/oder durch Mischen von unterschiedlichen Pulverchargen erreicht werden. Dies hat den Vorteil, dass dadurch geringere Schwankungen des Titanoxid-Gehalts über den späteren Grundkörper eingestellt werden können, als dies bei den bisherigen Herstellungsverfahren möglich ist. Dies führt zu einer vorteilhaften geringeren Schwankung des Wärmeausdehnungskoeffizienten über den Grundkörper.

Je kleiner die Abweichung, desto geringer die lokalen Inhomogenitäten in dem unter anderem von dem Titanoxid-Gehalt abhängigen Wärmeausdehnungskoeffizienten. Dieser wird weiterhin durch ein während des temporären Erhitzens des Grundkörpers oder danach durchgeführten Temperverfahren und lokal durch einen mit der Korngröße variierenden Titanoxid-Gehalt und der Homogenität der Korngrößen im Materialgemisch beeinflusst. Zur Einstellung des vorbestimmten Wärmeausdehnungskoeffizienten kann also in einem ersten Schritt eine geringe Inhomogenität des Titanoxidgehalts des Pulvers eingestellt werden und in einem nachfolgenden Temperverfahren der Wärmeausdehnungskoeffizient final eingestellt werden.

Das Soot-Verfahren kann zur Verbesserung des nachfolgenden Temperprozesses unter Sauerstoffmangel geführt werden, wodurch sich vermehrt Sauerstofffehlstellen in dem im Verfahren erzeugten Siliziumoxid (Si₂O) ausbilden. Durch die dadurch vermehrt auftretenden Silizium - Silizium Bindungen (Si-Si) wird ein zusätzlicher möglicher Bindungswinkel eingeführt, welcher eine bessere Entspannungsmöglichkeit bei hohen Temperaturen und somit eine bessere Temperbarkeit bewirkt.

Insbesondere kann im Soot-Verfahren mindestens ein weiterer Stoff zur Veränderung der physikalischen Eigenschaften der ersten Materialkomponente beigefügt werden, welcher eine kovalente Bindung eingeht. Hierfür eignet sich insbesondere Natrium (Na). Alternativ kann zur Erhöhung der Temperbarkeit des Grundkörpers durch eine Behandlung mit einem fluorhaltigen Gas oder Flüssigkeit mit Fluor dotiert werden.

Neben der chemischen Zusammensetzung kann die Korngröße des Pulvers eingestellt werden; sie kann insbesondere in einem Bereich von 100nm bis 500 µm liegen. Die Schwankungsbreite der Korngröße kann beispielsweise dadurch definiert werden, dass 90 % der Körner mindestens halb so groß wie der Mittelwert und höchstens doppelt so groß wie der Mittelwert aus dem vorbestimmten Bereich sind.

Weiterhin kann das Pulver zur Verringerung des OH-Gehalts auf einen OH-Gehalt von weniger als 100 ppm, bevorzugt von weniger als 30 ppm und besonders bevorzugt von weniger als 10 ppm, getrocknet werden. Ein geringer OH-Gehalt minimiert die Gefahr von innerhalb des Grundkörpers lokal unterschiedlich ausgebildeten Wärmeausdehnungskoeffizienten, welche durch die Diffusion von OH während eines nachfolgenden Sinterprozesses bewirkt wird. In diesem Fall verschlechtert sich die Temperbarkeit, wodurch sich auch, wie weiter oben erläutert die Kurve des Wärmeausdehnungskoeffizienten weniger gut anheben lässt.

In diesem Fall kann die Abweichung der Höhe des Wärmeausdehnungskoeffizienten, beziehungsweise die Lage der Kurve des Wärmeausdehnungskoeffizienten über der Temperatur im Vorfeld durch eine Reduzierung des Titanoxid-Gehalts um 0,1% bis 0,5 % kompensiert werden.

Dieses Verfahren hat den Vorteil, dass die Nulldurchgangstemperatur über den Titanoxid-Gehalt sehr gut vorhersagbar ist und daher zeitaufwendige Temperverfahren zur Einstellung zumindest minimiert werden können.

Alternativ kann das Pulver zur Erhöhung des OH-Gehalts auf einen auf das Gewicht bezogenen OH-Gehalt von 700 - 1200 ppm angefeuchtet werden. Dadurch kann wiederum die Temperbarkeit des durch das oben beschriebene Herstellungsverfahren erzeugten Grundkörpers weiter verbessert werden.

Es gilt also bei der Wahl des OH-Gehalts des Pulvers für die erste Materialkomponente ein Optimum zwischen dem Einstellen der Steigung des Wärmeausdehnungskoeffizienten über die Temperatur und der Nulldurchgangstemperatur, also dem absoluten Wärmeausdehnungskoeffizienten, beim Tempern und der Homogenität des Wärmeausdehnungskoeffizienten im Grundkörper zu finden.

Dabei kann ein zur Einstellung des Wärmeausdehnungskoeffizienten, seiner Steigung und der Nulldurchgangstemperatur benötigtes Tempern nach oder während des temporären Erhitzens des Zwischenkörpers im dritten Verfahrensschritt zur Herstellung des Grundkörpers durchgeführt werden.

Insbesondere kann beim Tempern mit Abkühlraten von 0,2 K/h bis 20K/h gearbeitet werden.

Der Wärmeausdehnungskoeffizient des Materials des Grundkörpers wird durch das erfindungsgemäße Herstellungsverfahren derart eingestellt, dass jeder Spiegel bei einer vorbestimmten Temperatur, der sogenannten Nulldurchgangstemperatur, einen Wärmeausdehnungskoeffizienten von Null aufweist. Weiterhin wird die Steigung des Wärmeausdehnungskoeffizienten über die Temperatur so flach wie möglich ausgebildet. Zur Beeinflussung der Nulldurchgangstemperatur und der Steigung des Wärmeausdehnungskoeffizienten können neben den bereits erläuterten noch weitere Maßnahmen angewendet werden.

Im Fall von eines mit Sauerstofffehlstellen hergestellten Pulvers ist es denkbar, den Grundkörper in Sauerstoffgas zu sintern, wobei der Sauerstoff dazu führt, dass sich die Sauerstofffehlstellen in normale Matrixbindungen in (Si-O-Si) umwandeln. Da dies bei der Sintertemperatur geschieht, ist die Matrix begrenzt fließfähig, aufgrund dessen eine Umwandlung bevorzugt an Stellen mit erhöhter lokaler Verspannung stattfinden wird, wodurch eine vorteilhafte Entspannung im Grundkörper herbeigeführt wird.

Weiterhin kann während des temporären Erhitzens ein statischer Druck auf den Zwischenkörper ausgeübt werden. Beim sogenannten Sintern wird ein vorher durch Druck oder durch das oben beschriebene Verfahren vorgeformter Zwischenkörper aus Pulver auf eine Temperatur erhitzt, welche nahe der Schmelztemperatur des Materials liegt, so dass eine Verbindung der einzelnen Körner des Pulvers durch Verschmelzen zu einem zumindest nahezu porenfreien Körper erreicht werden kann.

Bei einem weiteren mit einem statischen Druck arbeitenden Verfahren, dem sogenannten Heiß-Isostatischen-Pressen, wird ein Pulver oder Feststoff, aber auch bereits vorgeformte Zwischenkörper, unter der Kombination von einem statischen Druck, wie beispielsweise in einem Druckbehälter, und gleichzeitiger Erwärmung zu einem porenfreien Grundkörper verbunden. Damit der statische Druck nur von außen auf das Pulver oder den späteren Grundkörper einwirkt, kann im Fall eines Pulvers dieses in einen deformierbaren gasdichten Behälter gefüllt werden. Ist bereits ein Zwischenkörper vorhanden, kann dieser direkt in den Druckbehälter gelegt werden, wobei der Zwischenkörper eine gasdichte Außenschicht aufweisen muss. Es ist auch möglich, in einem an sich vollständig gesinterten Körper Restblasen zu schließen.

Weiterhin kann mindestens eine Funktionsfläche, wie beispielsweise eine optische Wirkfläche eines optischen Elements, aus dem ausgehärteten Materialgemisch des Grundkörpers mittels eines abrasiven Verfahrens nachbearbeitet werden. Der Zwischenkörper kann mindestens teilweise mittels eines 3D-Druckverfahrens hergestellt werden.

Insbesondere kann die Titanoxidkonzentration über das Volumen des mit einem 3D-Druckverfahren hergestellten Teils des Zwischenkörpers variieren. Die Variation der Titanoxidkonzentration kann dabei durch die Verwendung von Materialgemischen mit unterschiedlichen Titanoxidkonzentrationen eingestellt werden. Abhängig vom Verfahren können dadurch die Titanoxidkonzentrationen des Materialgemischs pro Schicht, innerhalb einer Schicht oder, wie im Fall des weiter unten näher erläuterten Polyjet-Verfahrens für jeden Auftrag eines weiteren Materialgemisches, beispielsweise in Tropfenform, eingestellt werden. Dabei werden die Materialgemische pro Schicht oder pro Teilauftrag innerhalb einer Schicht gewechselt oder kontinuierlich gemischt, wodurch eine vorbestimmte Titanoxidkonzentration eingestellt werden kann.

Weiterhin kann der Zwischenkörper unter Verwendung einer Form hergestellt werden, insbesondere durch ein 3D-Druckverfahren in eine Form gedruckt werden. Dabei kann die Form bereits die genäherte Oberflächenform einer optischen Wirkfläche des zu schaffenden optischen Elementes enthalten. In diesem Fall kann sich beim Sintern an der Grenzfläche zur Form im Material des Grundkörpers eine gasundurchlässige Schicht bilden, die für einen späteren Verfahrensschritt, beispielsweise Heiß-Isostatisches Pressen, vorteilhaft ist.

Ein Grundkörper eines erfindungsgemäßen optischen Elementes, beispielsweise eines Multilayerspiegels, kann insbesondere nach einem der weiter oben beschriebenen Ausführungsformen des Verfahrens hergestellt sein.

Dieser kann sich dadurch auszeichnen, dass der OH-Gehalt des Materials des Grundkörpers auf das Gewicht bezogen kleiner als 100 ppm, bevorzugt kleiner als 30ppm und besonders bevorzugt kleiner als 10ppm beträgt. Daraus ergibt sich verfahrensbedingt eine Steigung des Wärmeausdehnungskoeffizienten des Grundkörpermaterials in einem Bereich von 1,5 ppb/K² und 2,3 ppb/K² bei 20°C.

Weiterhin kann der Titanoxid-Gehalt des Grundkörpermaterials mindestens 5% - 15%, insbesondere 6,7% - 8,5%, bezogen auf das Gewicht, betragen. Wie oben erwähnt, kann insbesondere bei einer trockenen Pulvermischung die Einstellung der Nulldurchgangstemperatur durch eine Reduzierung des Titanoxid-Gehalts bewirkt werden.

Der Grundkörper kann schichtweise aufgebaut sein und die Geometrie mindestens der äußeren Schichten kann mindestens bereichsweise an die Geometrie der Oberfläche des Grundkörpers angepasst sein. Bei einer Projektionsbelichtungsanlage für die Halbleiterlithographie, welche ein erfindungsgemäßes optisches Element umfasst, kann der Grundkörper des optischen Elementes schichtweise aufgebaut sein. Dabei können innerhalb des Grundkörpers Inhomogenitäten von Materialeigenschaften, wie beispielsweise dem Wärmeausdehnungskoeffizienten vorhanden sein. Die Inhomogenitäten können durch die Verteilung von Materialkomponenten im Materialgemisch und/oder das Herstellverfahren bewirkt werden. In dem Fall, dass die Inhomogenitäten in einer Ebene parallel zur optischen Wirkfläche eine Vorzugsrichtung aufweisen, wie beispielweise Effekte, welche durch ein 3D-Druckverfahren bewirkt werden, ist es vorteilhaft, wenn das optische Element derart in der Projektionsbelichtungsanlage angeordnet ist, dass die Richtung der größten Inhomogenitäten im Wesentlichen senkrecht zu einer Scanrichtung der Projektionsbelichtungsanlage verläuft. Dies hat den Vorteil, dass die durch die Inhomogenitäten verursachten Abbildungsfehler vorteilhafterweise mindestens teilweise während des Scanvorgangs herausgemittelt werden können.

Das Verfahren ermöglicht die einfache Herstellung komplexer Geometrien bei gleichzeitiger Einstellung des Wärmeausdehnungskoeffizienten und der Nulldurchgangstemperatur, wobei es verschiedene Prozessparameter gibt, die teilweise einen gegenläufigen Einfluss haben. Die weiter oben beschriebenen Kombinationsmöglichkeiten und Bereiche sind nicht abschließend.

Das Verfahren zur Herstellung eines Grundkörpers für ein optisches Element mittels eines additiven Verfahrens gemäß Anspruch 1 umfasst folgende Verfahrensschritte:
- Bereitstellen eines ersten Materialgemisches, umfassend ein erstes Trägermaterial und ein erstes Strukturmaterial
- Bereitstellen eines zweiten Materialgemisches, umfassend ein zweites Trägermaterial und ein zweites Strukturmaterial
- wobei die Trägermaterialien mindestens ein Monomer und/oder mindestens ein Oligomer umfassen und wobei die Strukturmaterialien sich hinsichtlich ihrer Zusammensetzung unterscheiden
- Bildung eines Zwischenkörpers unter Zusammenführung der Materialgemische und Polymerisation der Trägermaterialien
- Fertigstellung mindestens eines Teils des Grundkörpers durch Erwärmung des Zwischenkörpers zum thermischen Verbinden der Strukturmaterialien und zur Entfernung der Trägermaterialien.

Unter einem Trägermaterial ist in diesem Zusammenhang ein Material zu verstehen, welches dazu dient, das Strukturmaterial temporär aufzunehmen und eine erste mechanisch stabile Struktur zur weiteren Bearbeitung zu schaffen. Im Unterschied dazu handelt es sich bei dem Strukturmaterial um dasjenige Material, welches nach der Fertigstellung des Grundkörpers in diesem verbleibt bzw. diesen bildet. Die erwähnte erste mechanisch stabile Struktur wird dabei durch Polymerisation der Monomere bzw. Oligomere des Trägermaterials erreicht. Dadurch, dass der Zwischenkörper unter Zusammenführung der Materialgemische hergestellt wird, kann erreicht werden, dass sich bereichsweise bestimmte erwünschte Eigenschaften des Zwischenkörpers und damit des späteren Grundkörpers erreichen lassen. Die Erwärmung des Zwischenkörpers zur Schaffung des Grundkörpers muss dabei nicht zwingend in einem einzigen Schritt erfolgen. Es ist durchaus denkbar, zunächst den Zwischenkörper so weit zu erwärmen, dass die gebildeten Polymere durch Verbrennung entfernt werden und im gleichen Schritt ein erster, noch lediglich bereichsweiser Verbund der einzelnen Partikel des Strukturmaterials geschaffen wird.

Ein massiver Grundkörper kann dann in einem nachfolgenden Sinterschritt erzeugt werden. Es versteht sich von selbst, dass zur Herstellung eines späteren optischen Elementes der so geschaffene Grundkörper noch mit weiteren Teilkörpern versehen werden kann, welche mit einem von dem beschriebenen Verfahren abweichenden Verfahren, insbesondere einem konventionellen Verfahren hergestellt wurden.

Dabei kann die Bildung eines Zwischenkörpers unter Verwendung eines Polyjet-Druckverfahrens erfolgen.

Durch das Polyjet-Verfahren können die Materialgemische an jedem Ort der Struktur des Zwischenkörpers in einem beliebig einstellbaren Verhältnis miteinander vermischt werden. Das Verfahren ist mit demjenigen Verfahren vergleichbar, welches bei einem Tintenstrahldrucker zur Anwendung kommt, wobei durch das Einstellen des Mischungsverhältnisses der üblicherweise drei Grundfarben (rot, gelb, blau) und schwarz alle Farben druckbar sind. Bei dem genannten Verfahren wird ein flüssiges Trägermaterial mit darin aufgeschlämmten Partikeln in Form kleiner Tröpfchen aufgebracht und sofort nach dem Aufbringen mittels ultravioletter Bestrahlung ausgehärtet. Weiterhin kann durch die Nutzung der Polymerisierung des Trägermaterials auch eine komplexe Zwischenstruktur einfach hergestellt werden.

Zur Schaffung eines Grundkörpers für ein optisches Element ist es vorteilhaft, wenn mindestens eines der Strukturmaterialien ein Glaspulver enthält. Dabei kann das Glaspulver beispielsweise Quarzglas und insbesondere die unter den Handelsnamen ULE oder Zerodur bekannten Gläser enthalten.

Weiterhin kann mindestens eines der Strukturmaterialien einen Zusatzstoff enthalten.

So kann beispielsweise ein erstes Strukturmaterial lediglich eines der genannten Gläser in Pulverform enthalten, während das zweite Strukturmaterial im Extremfall ausschließlich durch einen geeigneten Zusatzstoff gebildet ist. Ebenso ist es denkbar, dass beide Strukturmaterialien sich hinsichtlich der Art der Zusatzstoffe unterscheiden.

Ebenso können sich die Strukturmaterialien hinsichtlich der Konzentration der Zusatzstoffe unterscheiden.

Die Zusatzstoffe können insbesondere folgende Stoffe bzw. Stoffverbindungen umfassen: Titan, Titanoxid, Lithium, Aluminium, OH-Verbindungen.

Die genannten Zusatzstoffe eignen sich insbesondere dazu, eine Nulldurchgangstemperatur des Wärmeausdehnungskoeffizienten des Materials des entstehenden Grundkörpers einzustellen. Titan bewirkt beispielsweise die Möglichkeit, den Wärmeausdehnungskoeffizienten derart einzustellen, dass dieser zumindest für einen vorbestimmten Temperaturbereich null oder nahe-zu null sein kann. Andere Zusatzstoffe können beispielsweise das Material vor Versprödung durch elektromagnetische Strahlung schützen.

Auf diese Weise eröffnet sich die Möglichkeit, während der Herstellung des Zwischenkörpers die Stoffverteilung derart einzustellen, dass die Konzentration der Zusatzstoffe über den Grundkörper zu einer bei einer Nutzung des optischen Elementes ausgebildeten Temperaturverteilung im Grundkörper korrespondiert.

Mit anderen Worten kann die Nulldurchgangstemperatur bereichsweise derart angepasst werden, dass für eine im Betrieb der zugehörigen Projektionsbelichtungsanlage zu erwartende Temperaturverteilung im Grundkörper möglichst überall im Grundkörper die jeweilige Nulldurchgangstemperatur herrscht. Dadurch kann erreicht werden, dass bei Temperaturänderungen um die Nulldurchgangstemperatur herum über weite Teile des Volumens des Grundkörpers lediglich geringe Formänderungen aufgrund der Temperaturänderungen auftreten. Die optische Wirkfläche kann dabei ebenfalls derart ausgebildet sein, dass diese bei der gleichen Temperaturverteilung ihrer Solloberfläche entspricht.

Neben der Fokussierung auf eine typische Temperaturverteilung bei der Einstellung des Wärmeausdehnungskoeffizienten über den Grundkörper kann diese auch derart variieren, dass für eine Anzahl X von möglichen Temperaturverteilungen eine minimale größte Abweichung der optischen Wirkfläche von ihrer Solloberfläche bewirkt wird. In diesem Fall wäre die räumliche Verteilung der Zusatzstoffe im Grundkörper nicht punktuell auf eine bestimmte Temperaturverteilung hin optimiert, sondern es wäre ein zwar nicht perfektes, aber über die angesprochenen Temperaturverteilungen hinweg tolerierbares thermisches Ausdehnungsverhalten des Grundkörpers gewährleistet.

In einer vorteilhaften Variante der Erfindung kann die Konzentration der Zusatzstoffe mit zunehmendem Abstand von einer für eine optische Wirkfläche vorgesehenen Seite des Grundkörpers abnehmen.

Der Gradient der Konzentration kann sich dabei beispielsweise an dem für das Material bestimmten Wärmeflusses orientieren und damit unabhängig von einer konkreten Temperaturverteilung Deformationen verringern.

Weiterhin kann die Konzentration der Zusatzstoffe mit zunehmendem Abstand von einer für eine optische Wirkfläche vorgesehenen Seite des Grundkörpers bis zu einer gekühlten Schicht im Grundkörper konstant abnehmen.

Dies ist beispielsweise im Fall eines Titan aufweisenden Zusatzstoffes bei gekühlten optischen Elementen der Fall, welche in einem bestimmten Abstand von der optischen Wirkfläche Fluidleitungen zur Temperierung des Grundkörpers umfassen. Die Temperierung kann beispielsweise derart geregelt werden, dass unabhängig von der durch die optische Wirkfläche absorbierten Wärme, die Temperatur unterhalb, also auf der von der optischen Wirkfläche wegweisenden Seite der Fluidleitungen die Temperatur des Grundkörpers konstant gehalten werden kann. Der Wärmeübergangskoeffizient für diesen Bereich wäre dann im Gegensatz zu dem Bereich zwischen der optischen Wirkfläche und den Fluidleitungen konstant.

Es ist ebenso von Vorteil, wenn die Konzentration der Zusatzstoffe in einem vorbestimmten Teilbereich im Grundkörper derart eingestellt wird, dass der Wärmeausdehnungskoeffizient in dem Teilbereich größer als im restlichen Volumen des Grundkörpers ist.

Dies ist dann der Fall, wenn der von der Seite der optischen Wirkfläche abgewandte, untere Bereich des Grundkörpers bewusst thermisch deformiert werden soll. Diese vorbestimmte und geregelte Deformation drückt sich durch den Grundkörper bis zur optischen Wirkfläche durch, wobei gleichzeitig eine Erwärmung der optischen Wirkfläche durch Absorption durch elektromagnetische Strahlung keine parasitären Deformationen auf der optischen Wirkfläche bewirkt.

Das erfindungsgemäße Verfahren kann insbesondere zur Herstellung eines optischen Elementes für eine Projektionsbelichtungsanlage für die Halbleiterlithografie verwendet werden.

Ein erfindungsgemäßer Grundkörper für ein optisches Element gemäß Anspruch 12 ist mindestens teilweise mittels eines additiven Verfahrens hergestellt, wobei sich die Nulldurchgangstemperatur des thermischen Längenausdehnungskoeffizienten mindestens in einem Teilbereich des Grundkörpers stetig ändert.

Mit anderen Worten wird die Änderung der Nulldurchgangstemperatur derart gewählt, dass in dem genannten Teilbereich des Grundkörpers keine Sprünge auftreten. Dadurch wird erreicht, dass der entsprechende Teilbereich des Grundkörpers zwar lokal unterschiedliche Wärmeausdehnungskoeffizienten haben kann, jedoch keine scharfen Grenzflächen zwischen Bereichen unterschiedlicher Wärmeausdehnungskoeffizienten existieren. Dies wiederum hat zur Folge, dass bei Temperaturänderungen der Grundkörper zwar lokal unterschiedlich reagiert, es jedoch nicht zu Spannungsspitzen an Grenzflächen zwischen Bereichen unterschiedlicher thermischer Ausdehnungskoeffizienten kommt.

Insbesondere kann die Änderung der Nulldurchgangstemperatur in einem Bereich von 20° Celsius bis 65° Celsius bei mehr als 1 K/mm liegen.

In einer vorteilhaften Ausführungsform der Erfindung kann die über den Grundkörper zumindest teilweise variierende Nulldurchgangstemperatur zu einer bei einer Nutzung des optischen Elementes ausgebildeten Temperaturverteilung im Grundkörper korrespondieren.

Durch die beschriebene Maßnahme wird erreicht, dass im Falle des Vorliegens der angesprochenen Temperaturverteilung der Grundkörper überall eine Temperatur aufweist, die im Bereich der Nulldurchgangstemperatur liegt. Damit werden, wie bereits oben angesprochen, thermisch induzierte Längenänderungen über den Grundkörper hinweg minimiert. Die angesprochene Variation der Nulldurchgangstemperatur über das Material des Grundkörpers hinweg kann insbesondere auf im Vorfeld bereits bekannte Intensitätsverteilungen der elektromagnetischen Einstrahlung auf das optische Element, also im Ergebnis auf bereits bekannte Settings, angepasst werden. Ebenso können die entsprechenden Anpassungen in den der optischen Wirkfläche benachbarten Bereichen des Grundkörpers vorgenommen werden.

Die angesprochene Einstellung des thermischen Ausdehnungskoeffizienten kann jedoch nicht nur dazu verwendet werden, thermisch induzierte Längenänderungen im Material des Grundkörpers zu minimieren. Es ist ebenso denkbar, gezielt Bereiche im Grundkörper zu erzeugen, in welchen der Wärmeausdehnungskoeffizient gegenüber der Umgebung erhöht ist.

In diesem Fall besteht die Möglichkeit, durch Erwärmung oder auch Kühlung des entsprechenden Bereiches gezielt Deformationen auf der Wirkfläche des optischen Elementes hervorzurufen.

Eine Projektionsbelichtungsanlage für die Halbleiterlithographie, die optische Elemente umfasst, welche im Hinblick auf die verwendeten Grundkörper ausgeführt sind wie beschrieben, zeichnet sich durch eine erhöhte Robustheit gegenüber thermischen Einflüssen aus.

Ein weiterer Grundkörper für ein optisches Element, welcher mindestens einen Aktuator und/oder Sensor umfasst, zeichnet sich dadurch aus, dass mindestens in einer additiv gefertigten Teilstruktur des Grundkörpers mindestens eine Aktuatorkomponente des Aktuators und/oder eine Sensorkomponente des Sensors integriert ist. Dies hat den Vorteil, dass die Aktuatorkomponente und/oder Sensorkomponente näher an eine optische Wirkfläche oder andere Funktionselemente, wie beispielsweise Fluidkanäle, des Grundkörpers angeordnet werden können. Dies kann eine unmittelbare Erfassung einer Deformation der optischen Wirkfläche ermöglichen, wodurch die Genauigkeit und im Fall eines Thermalsensors auch die Reaktionszeit auf eine Änderung der Temperatur auf der optischen Wirkfläche vorteilhaft verbessert werden.

Insbesondere kann es sich bei der Aktuatorkomponente und/oder der Sensorkomponente um ein elektrisch leitfähiges Element handeln. Das elektrisch leitfähige Element kann beispielsweise als Draht, insbesondere als Heizdraht ausgebildet sein oder elektrisch leitfähige Partikel umfassen. Der Draht kann beispielsweise bei der Herstellung des Grundkörpers mit einem 3D-Druckverfahren während des Druckens an einer vorbestimmten Stelle eingelegt werden. Die Partikel können bei einem nachfolgend erläuterten 3-D Druckverfahren unmittelbar in einer der zum Drucken verwendeten Materialmischungen integriert sein und an vorbestimmten Positionen im Grundkörper gedruckt werden. In einer weiteren Variante der Erfindung kann die Aktuatorkomponente und/oder die Sensorkomponente elektrisch leitfähige Bauteile umfassen. Unter elektrisch leitfähigen Bauteilen sind dabei insbesondere Plättchen oder auch kurze Draht- bzw. Leiterabschnitte zu verstehen, welche ohne weitere Kontaktierung im Material des Grundkörpers integriert sind. Sie unterscheiden sich von den oben genannten Partikeln im Wesentlichen nur dadurch, dass sie in der Regel nicht unmittelbar mitgedruckt werden können, weil sie eine erheblich größere Ausdehnung als die Partikel aufweisen. Nichtsdestoweniger besteht selbstverständlich die Möglichkeit, die Bauteile zwischen dem Auftrag zweier Schichten in einem additiven Verfahren in das Material des Grundkörpers zu integrieren. Hierzu könnte beispielsweise ein 3-D Druck kurz unterbrochen werden, das entsprechende Bauteil eingelegt und dann der Druck fortgesetzt werden.

Im Falle der Verwendung der Komponenten als Aktuatoren kann in den elektrisch leitfähigen Elementen ein elektrischer Strom erzeugt werden, worauf sich die Elemente aufgrund ihres Ohmschen Widerstandes erwärmen. Damit erwärmt sich auch das Material des Grundkörpers in der Umgebung der leitfähigen Elemente, welches sich daraufhin verformt, insbesondere ausdehnt, so dass an der erwünschten Stelle im Grundkörper eine Deformation erreicht wird. Es ist möglich, beispielsweise im Fall von Heizdrähten, die Heizdrähte direkt galvanisch mit einer Spannungsquelle zu verbinden, um den erforderlichen Strom zu erzeugen. Im Falle der Verwendung von Partikeln oder Bauteilen ohne galvanische Kontaktierung mit einer Spannungsquelle besteht die Möglichkeit, den notwendigen elektrischen Strom durch Induktion zu erzeugen. Hierzu können ebenfalls im Grundkörper Induktionsspulen integriert werden, welche bei dem Anlegen einer Wechselspannung ein magnetisches Wechselfeld erzeugen und auf diese Weise Wirbelströme in den Partikeln bzw. Bauteilen verursachen.

Die Aktuatorkomponente und/oder die Sensorkomponente kann magnetisierbare Elemente umfassen. Diese magnetisierbaren Elemente können ähnlich ausgebildet sein wie die bereits erwähnten Partikel bzw. Bauteile; sie können insbesondere auch mit diesen zusammenfallen, da sich Magnetisierbarkeit und elektrische Leitfähigkeit nicht ausschließen. Im Falle von magnetisierbaren Elementen kann eine erwünschte Deformation durch die Erzeugung eines Magnetfeldes im Bereich der magnetisierbaren Elemente erreicht werden. Dies lässt sich beispielsweise dadurch erreichen, dass an Induktionsspulen in der Nähe der magnetisierbaren Elemente eine Gleichspannung angelegt wird, sodass sich im Bereich der magnetisierbaren Elemente ein zeitlich stabiles Magnetfeld ausbildet, worauf die Elemente eine Magnetkraft erfahren und es zu einer Deformation des umgebenden Materials kommt. In diesem Fall werden die Induktionsspulen, also in der Art von Elektromagneten, verwendet. Es besteht damit prinzipiell auch die Möglichkeit, mit derselben Anordnung aus Spulen und elektrisch leitfähigen/magnetisierbaren Elementen einerseits eine Deformation mittels thermischer Ausdehnung, andererseits aber auch mittels magnetischer Kraft zu erreichen. Für den Fall, dass es sich um magnetisierbare und elektrisch leitfähige Elemente handelt, ist bei einem Betrieb der Spulen als Induktionsspulen dafür Sorge zu tragen, dass die Frequenz der angelegten Wechselspannung einen ausreichenden Abstand zu den mechanischen Eigenfrequenzen des Grundkörpers einhält, um unerwünschte mechanische Schwingungen im Grundkörper zu vermeiden.

Für den Betrieb der oben genannten Elemente als Sensoren bestehen verschiedene Möglichkeiten. So kann beispielsweise die Temperaturabhängigkeit des Ohmschen Widerstandes bei der Verwendung von Heizdrähten dazu ausgenutzt werden, zu bestimmten Zeitpunkten den aktuellen Widerstand der Heizdrähte zu bestimmen und daraus die Temperatur in der Umgebung abzuleiten. Es ist prinzipiell auch denkbar, die integrierten Partikel bzw. Bauteile als Sensorkomponenten zu verwenden, da auch sie ein temperaturabhängiges Verhalten insbesondere ihrer elektrischen Eigenschaften zeigen. So wird beispielsweise die Induktivität einer im Bereich der Partikel bzw. Bauteile angeordneten Induktionsspule bis zu einem gewissen Grad von der ihrerseits temperaturabhängigen Permeabilität der benachbarten Partikel bzw. Bauteile und auch des umgebenden Materials abhängen. Aus einer Bestimmung der aktuellen Induktivität der Spulen können damit Rückschlüsse auf die Temperatur im Bereich der Spulen oder auch im Bereich der Partikel bzw. Bauteile gezogen werden.

Weiterhin kann es sich bei der Aktuatorkomponente und/oder der Sensorkomponente um ein wärmeleitendes oder wärmeerzeugendes Element handeln. Dieses kann als eine Heatpipe, Thermoelement oder ebenfalls als ein Kupferdraht ausgebildet sein. Die wärmeleitenden Elemente können mit einer Wärmequelle und/oder Wärmesenke verbunden sein und als Thermalaktuator eingesetzt werden. Ebenso können die integrierten wärmeleitenden Elemente auch lediglich als Verlängerung eines Temperatursensors Anwendung finden.

Ein Verfahren zur Herstellung eines Grundkörpers für ein optisches Element mit einem additiven Verfahren nicht gemäß der Erfindung umfasst folgende Verfahrensschritte:
- Herstellung mindestens eines als Anbindungsgeometrie ausgebildeten Teilkörpers einer vorbestimmten Struktur des Grundkörpers mit einem Polyjetverfahren, wobei das zur Herstellung des Grundkörpers verwendete Materialgemisch ein Trägermaterial mit mindestens einem Monomer und/oder Oligomer und ein Strukturmaterial mit einem Glaspulver aufweist.
- Erwärmung des im vorangegangenen Verfahrensschritt polymerisierten Grundkörpers zum thermischen Verbinden der Glaspulverbestandteile und zur Verbrennung des Polymers.
- Sintern des Grundkörpers.

Das Verfahren ermöglicht es nahezu beliebige Geometrien herzustellen, wobei im Endprodukt keine Übergänge zwischen den beim Drucken der Struktur erzeugten Schichten mehr nachweisbar sind.

Weiterhin können zwei unterschiedliche Materialgemische bei der Herstellung des Grundkörpers Anwendung finden. Dadurch können die Eigenschaften in unterschiedlichen Bereichen des Grundkörpers an unterschiedliche Anforderungen, wie beispielsweise niedriger Wärmeausdehnungskoeffizient, hohe Elastizität oder hohe Steifigkeit angepasst werden.

Insbesondere können eine Aktuatorkomponenten und/oder Sensorkomponenten umfassende Teilstruktur des Grundkörpers und der Grundkörper aus zwei unterschiedlichen Materialgemischen hergestellt sein. Dadurch kann beispielweise die Anbindungsgeometrie, wie beispielsweise das weiter oben beschriebene Entkopplungselement mit seinen Verbindungselementen mit einem ersten Materialgemisch mit hoher Elastizität hergestellt werden. Der restliche Grundkörper kann aus einem zweiten Materialgemisch mit hoher Steifigkeit hergestellt werden.

Insbesondere kann der Grundkörper eine zweite Teilstruktur umfassen, wobei dieser mit einem herkömmlichen Fertigungsverfahren hergestellt sein kann. Die einzelnen Teilstrukturen können formschlüssig oder stoffschlüssig miteinander zu dem Grundkörper verbunden werden.

Nachfolgend werden Ausführungsbeispiele und Varianten der Erfindung anhand der Zeichnung näher erläutert. Es zeigen
- Figur 1: schematisch im Meridionalschnitt eine Projektionsbelichtungsanlage für die EUV-Projektionslithografie,
- Figur 2: schematisch im Meridionalschnitt eine Projektionsbelichtungsanlage für die DUV-Projektionslithografie,
- Figur 3: ein Flussdiagramm zu einem erfindungsgemäßen Herstellungsverfahren,
- Figur 4: einen erfindungsgemäßen Grundkörper,
- Figur 5: eine 3D-Druckmaschine (Polyjet) zur Anwendung des erfindungsgemäßen Verfahrens,
- Figur 6: eine schematische Detaildarstellung des Grundkörpers zur Erläuterung des Verfahrens,
- Figur 7: ein Flussdiagramm zu einem weiteren erfindungsgemäßen Herstellungsverfahren,
- Figur 8: eine weitere Ausführungsform der Erfindung,
- Figur 9: eine weitere Ausführungsform der Erfindung,
- Figur 10: eine weitere Ausführungsform der Erfindung, und
- Figur 11: ein Flussdiagramm zu einem alternativen erfindungsgemäßen Herstellverfahren.

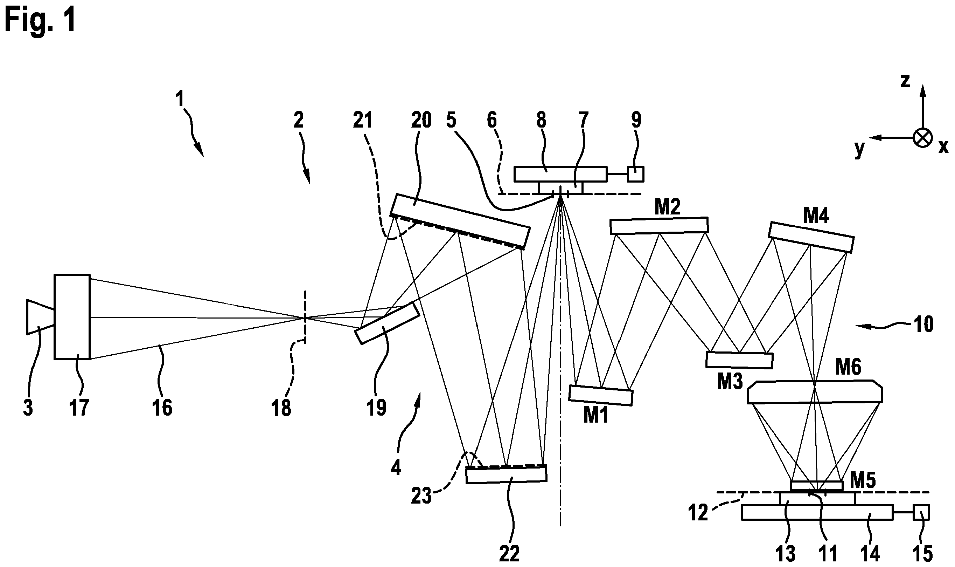

Im Folgenden werden zunächst unter Bezugnahme auf die Figur 1 exemplarisch die wesentlichen Bestandteile einer Projektionsbelichtungsanlage 1 für die Mikrolithografie beschrieben. Die Beschreibung des grundsätzlichen Aufbaus der Projektionsbelichtungsanlage 1 sowie deren Bestandteile sind hierbei nicht einschränkend verstanden.

Eine Ausführung eines Beleuchtungssystems 2 der Projektionsbelichtungsanlage 1 hat neben einer Strahlungsquelle 3 eine Beleuchtungsoptik 4 zur Beleuchtung eines Objektfeldes 5 in einer Objektebene 6. Bei einer alternativen Ausführung kann die Lichtquelle 3 auch als ein zum sonstigen Beleuchtungssystem separates Modul bereitgestellt sein. In diesem Fall umfasst das Beleuchtungssystem die Lichtquelle 3 nicht.

Beleuchtet wird ein im Objektfeld 5 angeordnetes Retikel 7. Das Retikel 7 ist von einem Retikelhalter 8 gehalten. Der Retikelhalter 8 ist über einen Retikelverlagerungsantrieb 9 insbesondere in einer Scanrichtung verlagerbar.

In der Figur 1 ist zur Erläuterung ein kartesisches xyz-Koordinatensystem eingezeichnet. Die x-Richtung verläuft senkrecht zur Zeichenebene hinein. Die y-Richtung verläuft horizontal und die z-Richtung verläuft vertikal. Die Scanrichtung verläuft in der Fig. 1 längs der y-Richtung. Die z-Richtung verläuft senkrecht zur Objektebene 6.

Die Projektionsbelichtungsanlage 1 umfasst eine Projektionsoptik 10. Die Projektionsoptik 10 dient zur Abbildung des Objektfeldes 5 in ein Bildfeld 11 in einer Bildebene 12. Die Bildebene 12 verläuft parallel zur Objektebene 6. Alternativ ist auch ein von 0° verschiedener Winkel zwischen der Objektebene 6 und der Bildebene 12 möglich.

Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrieb 15 kann synchronisiert zueinander erfolgen.

Bei der Strahlungsquelle 3 handelt es sich um eine EUV-Strahlungsquelle. Die Strahlungsquelle 3 emittiert insbesondere EUV-Strahlung 16, welche im Folgenden auch als Nutzstrahlung, Beleuchtungsstrahlung oder Beleuchtungslicht bezeichnet wird. Die Nutzstrahlung hat insbesondere eine Wellenlänge im Bereich zwischen 5 nm und 30 nm. Bei der Strahlungsquelle 3 kann es sich um eine Plasmaquelle handeln, zum Beispiel um eine LPP-Quelle (Laser Produced Plasma, mithilfe eines Lasers erzeugtes Plasma) oder um eine DPP-Quelle (Gas Discharged Produced Plasma, mittels Gasentladung erzeugtes Plasma). Es kann sich auch um eine synchrotronbasierte Strahlungsquelle handeln. Bei der Strahlungsquelle 3 kann es sich um einen Freie-Elektronen-Laser (Free-Electron-Laser, FEL) handeln.

Die Beleuchtungsstrahlung 16, die von der Strahlungsquelle 3 ausgeht, wird von einem Kollektor 17 gebündelt. Bei dem Kollektor 17 kann es sich um einen Kollektor mit einer oder mit mehreren ellipsoidalen und/oder hyperboloiden Reflexionsflächen handeln. Die mindestens eine Reflexionsfläche des Kollektors 17 kann im streifenden Einfall (Grazing Incidence, GI), also mit Einfallswinkeln größer als 45° gegenüber der Normalenrichtung der Spiegeloberfläche, oder im normalen Einfall (Normal Incidence, NI), also mit Einfallwinkeln kleiner als 45°, mit der Beleuchtungsstrahlung 16 beaufschlagt werden. Der Kollektor 17 kann einerseits zur Optimierung seiner Reflektivität für die Nutzstrahlung und andererseits zur Unterdrückung von Falschlicht strukturiert und/oder beschichtet sein.

Nach dem Kollektor 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Strahlungsquelle 3 und den Kollektor 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Bei dem Umlenkspiegel 19 kann es sich um einen planen Umlenkspiegel oder alternativ um einen Spiegel mit einer über die reine Umlenkungswirkung hinaus bündelbeeinflussenden Wirkung handeln. Alternativ oder zusätzlich kann der Umlenkspiegel 19 als Spektralfilter ausgeführt sein, der eine Nutzlichtwellenlänge der Beleuchtungsstrahlung 16 von Falschlicht einer hiervon abweichenden Wellenlänge trennt. Sofern der erste Facettenspiegel 20 in einer Ebene der Beleuchtungsoptik 4 angeordnet ist, die zur Objektebene 6 als Feldebene optisch konjugiert ist, wird dieser auch als Feldfacettenspiegel bezeichnet. Der erste Facettenspiegel 20 umfasst eine Vielzahl von einzelnen ersten Facetten 21, welche im Folgenden auch als Feldfacetten bezeichnet werden. Von diesen Facetten 21 sind in der Fig. 1 nur beispielhaft einige dargestellt.

Die ersten Facetten 21 können als makroskopische Facetten ausgeführt sein, insbesondere als rechteckige Facetten oder als Facetten mit bogenförmiger oder teilkreisförmiger Randkontur. Die ersten Facetten 21 können als plane Facetten oder alternativ als konvex oder konkav gekrümmte Facetten ausgeführt sein.

Wie beispielsweise aus der DE 10 2008 009 600 A1 bekannt ist, können die ersten Facetten 21 selbst jeweils auch aus einer Vielzahl von Einzelspiegeln, insbesondere einer Vielzahl von Mikrospiegeln, zusammengesetzt sein. Der erste Facettenspiegel 20 kann insbesondere als mikroelektromechanisches System (MEMS-System) ausgebildet sein. Für Details wird auf die DE 10 2008 009 600 A1 verwiesen.

Zwischen dem Kollektor 17 und dem Umlenkspiegel 19 verläuft die Beleuchtungsstrahlung 16 horizontal, also längs der y-Richtung.

Im Strahlengang der Beleuchtungsoptik 4 ist dem ersten Facettenspiegel 20 nachgeordnet ein zweiter Facettenspiegel 22. Sofern der zweite Facettenspiegel 22 in einer Pupillenebene der Beleuchtungsoptik 4 angeordnet ist, wird dieser auch als Pupillenfacettenspiegel bezeichnet. Der zweite Facettenspiegel 22 kann auch beabstandet zu einer Pupillenebene der Beleuchtungsoptik 4 angeordnet sein. In diesem Fall wird die Kombination aus dem ersten Facettenspiegel 20 und dem zweiten Facettenspiegel 22 auch als spekularer Reflektor bezeichnet. Spekulare Reflektoren sind bekannt aus der US 2006/0132747 A1, der EP 1 614 008 B1 und der US 6,573,978.

Der zweite Facettenspiegel 22 umfasst eine Mehrzahl von zweiten Facetten 23. Die zweiten Facetten 23 werden im Falle eines Pupillenfacettenspiegels auch als Pupillenfacetten bezeichnet.

Bei den zweiten Facetten 23 kann es sich ebenfalls um makroskopische Facetten, die beispielsweise rund, rechteckig oder auch hexagonal berandet sein können, oder alternativ um aus Mikrospiegeln zusammengesetzte Facetten handeln. Diesbezüglich wird ebenfalls auf die DE 10 2008 009 600 A1 verwiesen.

Die zweiten Facetten 23 können plane oder alternativ konvex oder konkav gekrümmte Reflexionsflächen aufweisen.

Die Beleuchtungsoptik 4 bildet somit ein doppelt facettiertes System. Dieses grundlegende Prinzip wird auch als Wabenkondensor (Fly's Eye Integrator) bezeichnet.

Es kann vorteilhaft sein, den zweiten Facettenspiegel 22 nicht exakt in einer Ebene, welche zu einer Pupillenebene der Projektionsoptik 10 optisch konjugiert ist, anzuordnen. Insbesondere kann der Pupillenfacettenspiegel 22 gegenüber einer Pupillenebene der Projektionsoptik 10 verkippt angeordnet sein, wie es zum Beispiel in der DE 10 2017 220 586 A1 beschrieben ist.

Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Bei einer weiteren, nicht dargestellten Ausführung der Beleuchtungsoptik 4 kann im Strahlengang zwischen dem zweiten Facettenspiegel 22 und dem Objektfeld 5 eine Übertragungsoptik angeordnet sein, die insbesondere zur Abbildung der ersten Facetten 21 in das Objektfeld 5 beiträgt. Die Übertragungsoptik kann genau einen Spiegel, alternativ aber auch zwei oder mehr Spiegel aufweisen, welche hintereinander im Strahlengang der Beleuchtungsoptik 4 angeordnet sind. Die Übertragungsoptik kann insbesondere einen oder zwei Spiegel für senkrechten Einfall (NI-Spiegel, Normal Incidence Spiegel) und/oder einen oder zwei Spiegel für streifenden Einfall (GI-Spiegel, Gracing Incidence Spiegel) umfassen.

Die Beleuchtungsoptik 4 hat bei der Ausführung, die in der Fig. 1 gezeigt ist, nach dem Kollektor 17 genau drei Spiegel, nämlich den Umlenkspiegel 19, den Feldfacettenspiegel 20 und den Pupillenfacettenspiegel 22.

Bei einer weiteren Ausführung der Beleuchtungsoptik 4 kann der Umlenkspiegel 19 auch entfallen, so dass die Beleuchtungsoptik 4 nach dem Kollektor 17 dann genau zwei Spiegel aufweisen kann, nämlich den ersten Facettenspiegel 20 und den zweiten Facettenspiegel 22.

Die Abbildung der ersten Facetten 21 mittels der zweiten Facetten 23 beziehungsweise mit den zweiten Facetten 23 und einer Übertragungsoptik in die Objektebene 6 ist regelmäßig nur eine näherungsweise Abbildung.

Die Projektionsoptik 10 umfasst eine Mehrzahl von Spiegeln Mi, welche gemäß ihrer Anordnung im Strahlengang der Projektionsbelichtungsanlage 1 durchnummeriert sind.

Bei dem in der Figur 1 dargestellten Beispiel umfasst die Projektionsoptik 10 sechs Spiegel M1 bis M6. Alternativen mit vier, acht, zehn, zwölf oder einer anderen Anzahl an Spiegeln Mi sind ebenso möglich. Der vorletzte Spiegel M5 und der letzte Spiegel M6 haben jeweils eine Durchtrittsöffnung für die Beleuchtungsstrahlung 16. Bei der Projektionsoptik 10 handelt es sich um eine doppelt obskurierte Optik. Die Projektionsoptik 10 hat eine bildseitige numerische Apertur, die größer ist als 0,5 und die auch größer sein kann als 0,6 und die beispielsweise 0,7 oder 0,75 betragen kann.

Reflexionsflächen der Spiegel Mi können als Freiformflächen ohne Rotationssymmetrieachse ausgeführt sein. Alternativ können die Reflexionsflächen der Spiegel Mi als asphärische Flächen mit genau einer Rotationssymmetrieachse der Reflexionsflächenform gestaltet sein. Die Spiegel Mi können, genauso wie die Spiegel der Beleuchtungsoptik 4, hoch reflektierende Beschichtungen für die Beleuchtungsstrahlung 16 aufweisen. Diese Beschichtungen können als Multilayer-Beschichtungen, insbesondere mit alternierenden Lagen aus Molybdän und Silizium, gestaltet sein.

Die Projektionsoptik 10 hat einen großen Objekt-Bildversatz in der y-Richtung zwischen einer y-Koordinate eines Zentrums des Objektfeldes 5 und einer y-Koordinate des Zentrums des Bildfeldes 11. Dieser Objekt-Bild-Versatz in der y-Richtung kann in etwa so groß sein wie ein z-Abstand zwischen der Objektebene 6 und der Bildebene 12.

Die Projektionsoptik 10 kann insbesondere anamorphotisch ausgebildet sein. Sie weist insbesondere unterschiedliche Abbildungsmaßstäbe βx, βy in x- und y-Richtung auf. Die beiden Abbildungsmaßstäbe βx, βy der Projektionsoptik 10 liegen bevorzugt bei (βx, βy) = (+/- 0,25, +/- 0,125). Ein positiver Abbildungsmaßstab β bedeutet eine Abbildung ohne Bildumkehr. Ein negatives Vorzeichen für den Abbildungsmaßstab β bedeutet eine Abbildung mit Bildumkehr.

Die Projektionsoptik 10 führt somit in x-Richtung, das heißt in Richtung senkrecht zur Scanrichtung, zu einer Verkleinerung im Verhältnis 4:1.

Die Projektionsoptik 10 führt in y-Richtung, das heißt in Scanrichtung, zu einer Verkleinerung von 8:1.

Andere Abbildungsmaßstäbe sind ebenso möglich. Auch vorzeichengleiche und absolut gleiche Abbildungsmaßstäbe in x- und y-Richtung, zum Beispiel mit Absolutwerten von 0,125 oder von 0,25, sind möglich.

Die Anzahl von Zwischenbildebenen in der x- und in der y-Richtung im Strahlengang zwischen dem Objektfeld 5 und dem Bildfeld 11 kann gleich sein oder kann, je nach Ausführung der Projektionsoptik 10, unterschiedlich sein. Beispiele für Projektionsoptiken mit unterschiedlichen Anzahlen derartiger Zwischenbilder in x- und y-Richtung sind bekannt aus der US 2018/0074303 A1.

Jeweils eine der Pupillenfacetten 23 ist genau einer der Feldfacetten 21 zur Ausbildung jeweils eines Beleuchtungskanals zur Ausleuchtung des Objektfeldes 5 zugeordnet. Es kann sich hierdurch insbesondere eine Beleuchtung nach dem Köhlerschen Prinzip ergeben. Das Fernfeld wird mit Hilfe der Feldfacetten 21 in eine Vielzahl an Objektfeldern 5 zerlegt. Die Feldfacetten 21 erzeugen eine Mehrzahl von Bildern des Zwischenfokus auf den diesen jeweils zugeordneten Pupillenfacetten 23.

Die Feldfacetten 21 werden jeweils von einer zugeordneten Pupillenfacette 23 einander überlagernd zur Ausleuchtung des Objektfeldes 5 auf das Retikel 7 abgebildet. Die Ausleuchtung des Objektfeldes 5 ist insbesondere möglichst homogen. Sie weist vorzugsweise einen Uniformitätsfehler von weniger als 2 % auf. Die Felduniformität kann über die Überlagerung unterschiedlicher Beleuchtungskanäle erreicht werden.

Durch eine Anordnung der Pupillenfacetten kann geometrisch die Ausleuchtung der Eintrittspupille der Projektionsoptik 10 definiert werden. Durch Auswahl der Beleuchtungskanäle, insbesondere der Teilmenge der Pupillenfacetten, die Licht führen, kann die Intensitätsverteilung in der Eintrittspupille der Projektionsoptik 10 eingestellt werden. Diese Intensitätsverteilung wird auch als Beleuchtungssetting bezeichnet.

Eine ebenfalls bevorzugte Pupillenuniformität im Bereich definiert ausgeleuchteter Abschnitte einer Beleuchtungspupille der Beleuchtungsoptik 4 kann durch eine Umverteilung der Beleuchtungskanäle erreicht werden.

Im Folgenden werden weitere Aspekte und Details der Ausleuchtung des Objektfeldes 5 sowie insbesondere der Eintrittspupille der Projektionsoptik 10 beschrieben.

Die Projektionsoptik 10 kann insbesondere eine homozentrische Eintrittspupille aufweisen. Diese kann zugänglich sein. Sie kann auch unzugänglich sein.

Die Eintrittspupille der Projektionsoptik 10 lässt sich regelmäßig mit dem Pupillenfacettenspiegel 22 nicht exakt ausleuchten. Bei einer Abbildung der Projektionsoptik 10, welche das Zentrum des Pupillenfacettenspiegels 22 telezentrisch auf den Wafer 13 abbildet, schneiden sich die Aperturstrahlen oftmals nicht in einem einzigen Punkt. Es lässt sich jedoch eine Fläche finden, in welcher der paarweise bestimmte Abstand der Aperturstrahlen minimal wird. Diese Fläche stellt die Eintrittspupille oder eine zu ihr konjugierte Fläche im Ortsraum dar. Insbesondere zeigt diese Fläche eine endliche Krümmung.

Es kann sein, dass die Projektionsoptik 10 unterschiedliche Lagen der Eintrittspupille für den tangentialen und für den sagittalen Strahlengang aufweist. In diesem Fall sollte ein abbildendes Element, insbesondere ein optisches Bauelement der Übertragungsoptik, zwischen dem zweiten Facettenspiegel 22 und dem Retikel 7 bereitgestellt werden. Mit Hilfe dieses optischen Elements kann die unterschiedliche Lage der tangentialen Eintrittspupille und der sagittalen Eintrittspupille berücksichtigt werden.

Bei der in der Figur 1 dargestellten Anordnung der Komponenten der Beleuchtungsoptik 4 ist der Pupillenfacettenspiegel 22 in einer zur Eintrittspupille der Projektionsoptik 10 konjugierten Fläche angeordnet. Der Feldfacettenspiegel 20 ist verkippt zur Objektebene 6 angeordnet. Der erste Facettenspiegel 20 ist verkippt zu einer Anordnungsebene angeordnet, die vom Umlenkspiegel 19 definiert ist.

Der erste Facettenspiegel 20 ist verkippt zu einer Anordnungsebene angeordnet, die vom zweiten Facettenspiegel 22 definiert ist.

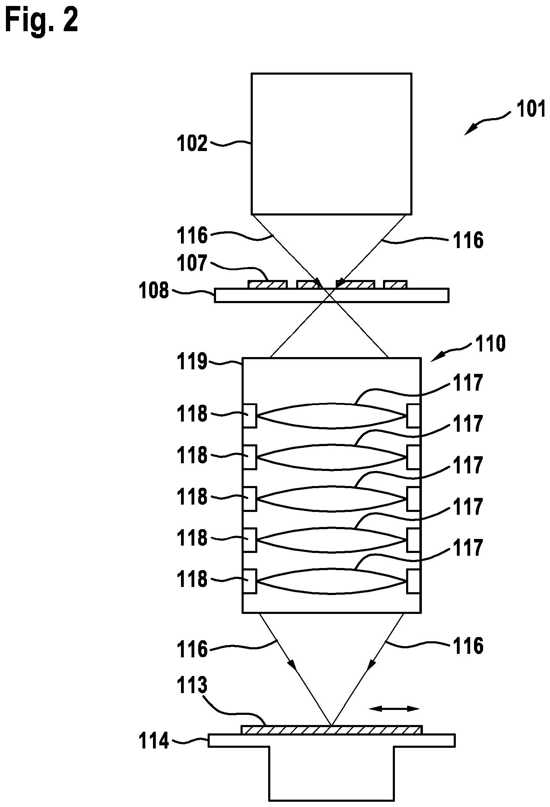

Figur 2 zeigt schematisch im Meridionalschnitt eine weitere Projektionsbelichtungsanlage 101 für die DUV-Projektionslithografie, in welcher die Erfindung eben-falls zur Anwendung kommen kann.

Der Aufbau der Projektionsbelichtungsanlage 101 und das Prinzip der Abbildung ist vergleichbar mit dem in Figur 1 beschriebenen Aufbau und Vorgehen. Gleiche Bauteile sind mit einem um 100 gegenüber Figur 1 erhöhten Bezugszeichen bezeichnet, die Bezugszeichen in Figur 2 beginnen also mit 101.

Im Unterschied zu einer wie in Figur 1 beschriebenen EUV-Projektionsbelichtungsanlage 1, können auf Grund der größeren Wellenlänge der als Nutzlicht verwendeten DUV-Strahlung 116 im Bereich von 100 nm bis 300 nm, insbesondere von 193 nm, in der DUV-Projektionsbelichtungsanlage 101 zur Abbildung beziehungsweise zur Beleuchtung refraktive, diffraktive und/oder reflexive optische Elementen 117, wie beispielsweise Linsen, Spiegeln, Prismen, Abschlussplatten und dergleichen verwendet werden. Die Projektionsbelichtungsanlage 101 umfasst dabei im Wesentlichen ein Beleuchtungssystem 102, einen Retikelhalter 108 zur Aufnahme und exakten Positionierung eines mit einer Struktur versehenen Retikels 107, durch welches die späteren Strukturen auf einem Wafer 113 bestimmt werden, einen Waferhalter 114 zur Halterung, Bewegung und exakten Positionierung eben dieses Wafers 113 und ein Projektionsobjektiv 110, mit mehreren optischen Elementen 117, die über Fassungen 118 in einem Objektivgehäuse 119 des Projektionsobjektives 110 gehalten sind.

Das Beleuchtungssystem 102 stellt eine für die Abbildung des Retikels 107 auf dem Wafer 113 benötigte DUV-Strahlung 116 bereit. Als Quelle für diese Strahlung 116 kann ein Laser, eine Plasmaquelle oder dergleichen Verwendung finden. Die Strahlung 116 wird in dem Beleuchtungssystem 102 über optische Elemente derart geformt, dass die DUV-Strahlung 116 beim Auftreffen auf das Retikel 107 die gewünschten Eigenschaften hinsichtlich Durchmesser, Polarisation, Form der Wellenfront und dergleichen aufweist.

Der Aufbau der nachfolgenden Projektionsoptik 101 mit dem Objektivgehäuse 119 unterscheidet sich außer durch den zusätzlichen Einsatz von refraktiven optischen Elementen 117 wie Linsen, Prismen, Abschlussplatten prinzipiell nicht von dem in Figur 1 beschriebenen Aufbau und wird daher nicht weiter beschrieben.

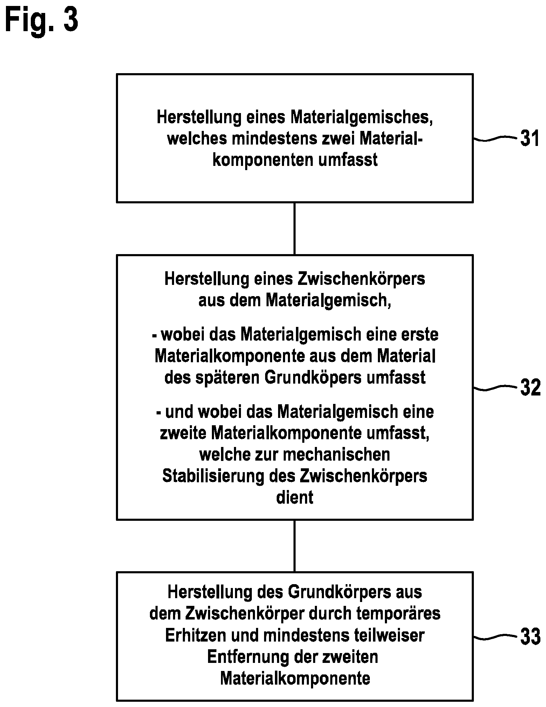

Figur 3 zeigt ein Flussdiagramm eines möglichen Herstellungsverfahrens für einen Grundkörper eines optischen Elementes für die Halbleiterlithografie, welches beispielsweise in einer der beiden in den vorangehenden Figuren beschriebenen Anlagen Verwendung finden kann.

In einem ersten Verfahrensschritt 31 wird ein Materialgemisch, welches mindestens zwei Materialkomponenten umfasst, hergestellt.

In einem zweiten Verfahrensschritt 32 wird aus dem Materialgemisch ein Zwischenkörper hergestellt, wobei das Materialgemisch mindestens eine erste Materialkomponente aus dem Material des späteren Grundkörpers umfasst und wobei das Materialgemisch eine zweite Materialkomponente umfasst, welche zur mechanischen Stabilisierung des Zwischenkörpers dient.

In einem dritten Verfahrensschritt 33 wird der Grundkörper aus dem Zwischenkörper durch temporäres Erhitzen und einer mindestens teilweisen Entfernung der zweiten Materialkomponente hergestellt.

Die erste Materialkomponente, welche ein Quarzglas, insbesondere ein mit Titanoxid dotiertes Quarzglas, umfasst, wird dem Materialgemisch als Pulver zugeführt. Dieses wird durch Zermahlen eines Ausgangsmaterials hergestellt, so dass die physikalischen Eigenschaften des Pulvers denen des späteren Grundkörpers entsprechen oder welches derart ausgebildet ist, dass nach dem erfindungsgemäßen Herstellungsverfahren die vorbestimmten physikalischen Eigenschaften des Grundkörpers geschaffen werden.

Die bei dem Zermahlen des Ausgangsmaterials verwendeten Werkzeuge werden vorteilhafterweise aus dem gleichen Material wie ein Material der ersten Materialkomponente hergestellt, bzw. aus in der ersten Materialkomponente verwendeten Materialien hergestellt, wodurch eine Verunreinigung der ersten Materialkomponente durch Abrieb des Werkzeugs vermieden werden kann. Weiterhin ist auch ein berührungsloses Verfahren, wie beispielsweise ein Ultraschallverfahren, zur Pulverisierung des Ausgangsmaterials anwendbar.

Alternativ kann die erste Materialkomponente durch ein sogenanntes Soot-Verfahren hergestellt werden, bei welchem Sand zunächst mit Kohlenstoff reduziert und das entstandene Silicium anschließend mit Chlor zu Siliziumtetrachlorid umgesetzt wird. Nachfolgend wird in einer Hochtemperaturpyrolyse ein homogenes Gemisch aus dampfförmigem Siliziumtetrachlorid, Wasserstoff, Sauerstoff und einem Inertgas mit einem Brenner in einem gekühlten Verbrennungsraum verbrannt. In der Flamme entstehen zunächst tröpfchenartige Siliziumdioxid-Partikel, die sich kettenartig aneinanderlagern und so über Verzweigungen dreidimensionale Sekundärpartikel bilden. Diese lagern sich wiederum zu Tertiärpartikeln zusammen, welche als Pulver in der Kammer ausfallen.

Die im Soot-Verfahren verwendete Brennerflamme kann dabei gezielt mit Sauerstoffmangel erzeugt werden, wodurch sich vermehrt Sauerstofffehlstellen in dem im Verfahren erzeugten Siliziumoxid (Si₂O) ausbilden. Durch die dadurch vermehrt auftretenden Silizium-Silizium Bindungen (Si-Si) wird ein zusätzlicher möglicher Bindungswinkel eingeführt, welcher eine bessere Entspannungsmöglichkeit bei hohen Temperaturen und somit eine bessere Temperbarkeit bewirkt. Dies vereinfacht die Einstellung der physikalischen Eigenschaften des Grundkörpers bezüglich des Wärmeausdehnungskoeffizienten und der weiter oben bereits beschriebenen Nulldurchgangstemperatur. Der Wärmeausdehnungskoeffizient des Materials des Grundkörpers wird durch das erfindungsgemäße Herstellungsverfahren derart eingestellt, dass jeder Spiegel bei einer vorbestimmten Temperatur, der sogenannten Nulldurchgangstemperatur, einen Wärmeausdehnungskoeffizienten von Null aufweist.

Weiterhin wird die Steigung des Wärmeausdehnungskoeffizienten über die Temperatur so flach wie möglich ausgebildet. Zur Beeinflussung der Nulldurchgangstemperatur und der Steigung des Wärmeausdehnungskoeffizienten können verschiedene Maßnahmen angewendet werden. Dabei hängt die Höhe des Wärmeausdehnungskoeffizienten zum Großteil vom prozentualen Anteil von Titanoxid in dem überwiegend Siliziumoxid aufweisenden Material ab, wobei mit steigendem Titanoxid-Gehalt der Wärmeausdehnungskoeffizient des Materialgemisches, also des Grundkörpers, sinkt, also eine Kurve des Wärmeausdehnungskoeffizienten über der Temperatur in negative y-Richtung verschoben wird. Dadurch wird gleichzeitig die Nulldurchgangstemperatur des Materialgemischs zu einer höheren Temperatur hin verschoben. Tempern des Grundkörpers bei einer Temperatur zwischen 900 °C und 1200 °C verschiebt einerseits die Kurve des Wärmeausdehnungskoeffizienten in positive y-Richtung, also nach oben, wodurch die Nulldurchgangstemperatur sinkt, und reduziert andererseits die Steigung der Kurve vorteilhaft.

Weiterhin ist es denkbar, den Grundkörper in Sauerstoffgas zu sintern, wobei der Sauerstoff dazu führt, dass sich die Sauerstofffehlstellen in normale Matrixbindungen in (Si-O-Si) umwandeln. Da dies bei der Sintertemperatur geschieht, ist die Matrix begrenzt fließfähig, so dass eine Umwandlung bevorzugt an Stellen mit erhöhter lokaler Verspannung stattfinden wird, wodurch eine Entspannung im Grundkörper herbeigeführt wird.

Daneben ist es denkbar, bereits im Soot-Verfahren Metalle beizufügen, welche eine kovalente Bindung eingehen. Dabei eignet sich insbesondere Natrium (Na). Alternativ kann das Pulver zur Erhöhung der Temperbarkeit des Grundkörpers durch eine Behandlung mit einem fluorhaltigen Gas oder Flüssigkeit mit Fluor dotiert werden.

Alternativ kann die Flamme auch mit Sauerstoffüberschuss betrieben werden, wodurch sich Peroxid-Zentren, also Bereiche mit einer Verbindung Si-O=O-Si, ausbilden. Diese können durch Sintern in einer reduzierenden Atmosphäre, wie beispielsweise Wasserstoffatmosphäre reduziert werden, wodurch sich normale Matrixbindungen und Wasserdampf bilden, die vor Abschluss des Sinterns entkommen können, insbesondere wenn unter vermindertem Druck oder zumindest bei sehr geringem Wasser-Dampfdruck gesintert wird. Neben der Wasserstoffatmosphäre kann alternativ auch im Vakuum oder in einer Kohlenmonoxid-(CO) oder Ammoniak-(NH3) Atmosphäre gesintert werden.

Insbesondere kann das Pulver nach dem Soot-Verfahren, nach welchem das Pulver einen auf das Gewicht bezogenen OH-Gehalt von 150 - 300 ppm aufweist, durch Anfeuchten auf einen OH-Gehalt von 700 - 1200 ppm gebracht werden, wodurch wiederum die Temperbarkeit des durch das oben beschriebene Herstellungsverfahren erzeugten Grundkörpers verbessert wird.

Alternativ kann das Pulver auch auf einen OH-Gehalt von weniger als 100 ppm, bevorzugt von weniger als 30 ppm und besonders bevorzugt von weniger als 10 ppm getrocknet werden. Ein geringer OH-Gehalt minimiert die Gefahr von innerhalb des Grundkörpers unterschiedlich ausgebildeten Wärmeausdehnungskoeffizienten, welche durch die Diffusion von OH während eines nachfolgenden Sinterprozesses bewirkt wird. In diesem Fall verschlechtert sich die Temperbarkeit, wodurch auch, wie weiter oben erläutert, sich die Kurve des Wärmeausdehnungskoeffizienten weniger gut anheben lässt. Die Abweichung der Höhe des Wärmeausdehnungskoeffizienten kann im Vorfeld durch eine Verringerung des Titanoxid-Gehalts um 0,1% bis 0,5 %, im Vergleich zu herkömmlich hergestellten Materialien, kompensiert werden. Dieses Verfahren hat den Vorteil, dass die Nulldurchgangstemperatur über den Titanoxid-Gehalt sehr gut vorhersagbar ist und daher zeitaufwendige Temperverfahren zur Einstellung der Nulldurchgangstemperatur zumindest minimiert werden können. Es gilt also bei der Wahl des OH-Gehalts des Pulvers für die erste Materialkomponente ein Optimum zwischen dem Einstellen der Steigung des Wärmeausdehnungskoeffizienten über die Temperatur und der Nulldurchgangstemperatur, also dem absoluten Wärmeausdehnungskoeffizienten, beim Tempern und der Homogenität des Wärmeausdehnungskoeffizienten im Grundkörper zu finden.

Der Zwischenkörper kann in dem hier beschriebenen Ausführungsbeispiel aus dem Materialgemisch durch ein sogenanntes Polyjet-Verfahren, welches mit einem Tintenstrahldruckverfahren vergleichbar ist, hergestellt werden. Der Zwischenkörper wird dabei schichtweise aufgebaut, wobei die minimale Auflösung von der durch den Drucker erzeugten Schichtdicke abhängt. Die Schichtdicke wird einerseits von der Korngröße der Materialkomponenten und im Fall des Polyjet-Verfahrens von der Dosierung des flüssigen Materialgemischs bestimmt.

Die Titanoxidkonzentration des verwendeten Materialgemisches kann durch die Verwendung von mindestens zwei Druckköpfen mit jedem Auftrag neu eingestellt werden, wodurch vorteilhafterweise die Titanoxidkonzentration gezielt über das Volumen des optischen Elementes eingestellt werden kann. Dadurch können in verschiedenen Bereichen des Grundkörpers unterschiedliche Nulldurchgangstemperaturen eingestellt werden, welche aus den im Betrieb auftretenden Temperaturverteilungen im Grundkörper abgeleitet werden können.

Insbesondere können durch die nahezu beliebige Gestaltung des Körpers beim Polyjetverfahren die letzten Schichten des Zwischenkörpers so ausgebildet sein, dass diese parallel zur späteren optischen Wirkfläche ausgebildet sind.

Alternativ kann der Zwischenkörper auch durch Lasersintern im Pulverbett oder ein Stereolithografieverfahren schichtweise erzeugt werden, um nur einige Möglichkeiten zu nennen.

Bei jedem dieser Verfahren und auch bei weiteren möglichen Herstellungsverfahren, wie beispielsweise einem Spritzgussverfahren, einem herkömmlichen Gießverfahren oder einem Prägeverfahren, wird ein Materialgemisch verwendet. Dabei ist die erste Materialkomponente, welche später den Grundkörper bildet, abgesehen von für das jeweilige Verfahren spezifischen Anforderungen, wie beispielsweise die weiter oben beschriebene Feuchte und oder Titanoxid-Konzentration, identisch. Die zweite Materialkomponente, welche maßgeblich die zur Bildung des für das Verfahren notwendigen physikalischen Eigenschaften, wie flüssig oder fest und der beim Spritzgießen wichtigen Schmelztemperatur des Materialgemischs bestimmt, unterscheidet sich dagegen signifikant.

Als weitere Variation kann ein 3D-Druck auch direkt in eine als Schale ausgebildete Form ausgeführt werden. Dadurch kann beispielsweise die Form der Oberfläche des Grundkörpers, auf welcher im weiteren Verfahren die optische Wirkfläche ausgebildet wird, vorbestimmt werden. Das Drucken in oder auf eine Schale hat den Vorteil, dass sich beim Sintern an der Grenzfläche zur Schale bereits eine gasdichte Schicht bildet, welche für ein später folgendes Heiß-Isostatisches-Pressen notwendig ist.

In dem Fall, dass bei einem 3D-Druckverfahren der Aufbau der Schichten auch parallel zur späteren optischen Wirkfläche erfolgt, so kann sich neben der vertikalen Schichtung auch eine innerhalb der vertikalen Schichten gerasterte horizontale Schichtung parallel zur Spiegeloberfläche ausbilden. Dadurch werden sowohl entlang der Druckrichtung als auch senkrecht dazu Inhomogenitäten im Wärmeausdehnungskoeffizienten bewirkt. Die Richtung mit den größeren Inhomogenitäten, welche beispielsweise durch Messungen bestimmt werden kann, wird senkrecht zu der in der Figur 1 und der Figur 2 erläuterten Scanrichtung der Projektionsbelichtungsanlagen ausgerichtet, so dass die Wirkung auf die Abbildungsqualität durch das Scannen ausgemittelt wird.

Der Zwischenkörper wird gesintert, wodurch die zweite Materialkomponente, welche in der beschriebenen Ausführungsform als Polymer ausgebildet ist, verbrennt und sich die einzelnen Körner des Pulvers der ersten Materialkomponente zum Grundkörper verbinden. Das Verbrennen der zweiten Materialkomponente und das Verbinden der Körner des Pulvers zum Grundkörper kann alternativ auch in zwei separaten Verfahrensschritten durchgeführt werden. In einem ersten Schritt wird die zweite Materialkomponente verbrannt (Pyrolyse), wobei sich die Körner des Pulvers dabei bereits punktweise verbinden. In einem zweiten Schritt wird der Grundkörper gesintert, wobei aus den bereits verbundenen Körnern ein porenfreier Grundkörper erzeugt wird. Weiterhin kann eine Entfernung eines erstens Teils des Polymers, wie beispielsweise Polyäthylenglykol, aus dem Zwischenkörper auch durch Einlegen in eine wässrige Flüssigkeit und der weitere Teil, wie beispielsweise Polyvinylbutyral, durch ein nachfolgendes Verbrennen (Pyrolyse) realisiert werden. Das zweistufige Vorgehen bei der Entfernung der verschiedenen Materialien der zweiten Materialkomponente hat den Vorteil, dass nach dem Auslösen des Polyäthylenglykol eine offenporige Struktur entsteht, wodurch die durch Pyrolyse zu entfernende Masse geringer ist und aus tieferen Schichten entfernt werden kann, wodurch wiederum die Wandstärke des Grundkörpers vorteilhaft größer ausgebildet werden kann.

Eine nach dem Sintern vorhandene Restporosität kann durch Heiß-Isostatisches-Pressen (HIP) geschlossen werden, wobei dazu die Oberfläche des Grundkörpers gasdicht geschlossen sein muss. Dies kann durch Anströmen der Oberflächen mit einem heißen Gas, welches bevorzugt ein inertes Gas umfasst, bewirkt werden.

Alternativ kann der Zwischenkörper auch in eine geeignete wässrige Lösung getaucht werden, die nur einige Mikrometer bis 1 mm tief eindringt und danach trocknet oder reagiert, wodurch eine bei der beim Heiß-Isostatischen-Pressen verwendeten Temperatur stabile, gasdichte Oberflächenschicht gebildet wird. Anstelle der Lösung kann auch eine Schmelze eines gemischten Glases, beispielsweise eines NatriumSilikat-Glases, verwendet werden, wodurch ebenfalls eine gasdichte Oberflächenschicht gebildet werden kann. Es ist ebenso denkbar, nach dem Verbrennen der zweiten Materialkomponente durch die weiter oben beschriebenen Verfahren eine gasdichte Oberflächenschicht auf den Zwischenkörper aufzubringen und auf ein Sintern des Zwischenkörpers zu verzichten. Dies hat den Vorteil, dass die Verbindung des Pulvers der ersten Materialkomponente zu einem porenfreien Glaskörper durch den beim Heiß-Isostatischen-Pressen höheren Druck bei niedrigeren Temperaturen erreicht wird. Dadurch wird die Gefahr einer Verschiebung und/oder einer Deformation von in dem Zwischenkörper integrierten Fluidkanälen, welche teilweise Innendurchmesser von wenigen µm aufweisen können, durch den auch in den Fluidkanälen wirkenden Druck bei der Verbindung des Pulvers vorteilhaft minimiert.

Das Tempern zum Einstellen der Steigung des Wärmeübergangskoeffizienten und der Nulldurchgangstemperatur, wie weiter oben erläutert, kann auch durch vorbestimmte Abkühlraten, welche im Bereich von 0.2 K/h bis 20K/h liegen können, beim Heiß-Isostatischen-Pressen durchgeführt werden. Ein weiterer Vorteil des Heiß-Isostatischen-Pressens besteht darin, dass, je weiter die verwendete Temperatur von der Schmelztemperatur des Grundkörpermaterials entfernt ist, desto formstabiler das Material ist, wodurch die Geometrie und die Lage von im Grundkörper eingebrachten Strukturen, beispielsweise von Fluidkanälen erhalten bleibt.

Der beim Sintern und/oder beim Heiß-Isostatischen-Pressen durch das Verbinden der Körner und das Auslösen der zweiten Materialkomponente auftretende Schrumpf des Grundkörpers gegenüber dem Zwischenkörper, welcher in Abhängigkeit von dem prozentualen Anteil der ersten Materialkomponente in dem Materialgemisch in einem Bereich von 5% bis 20%, insbesondere 5% bis 10% liegt, kann vorgehalten werden. Es ist über Versuche anhand der konkreten Geometrien des Grundkörpers auch möglich, auf Basis von Inhomogenitäten im Materialgemisch oder durch das Verfahren bewirkten nichtlinearen Schrumpf zu kompensieren.

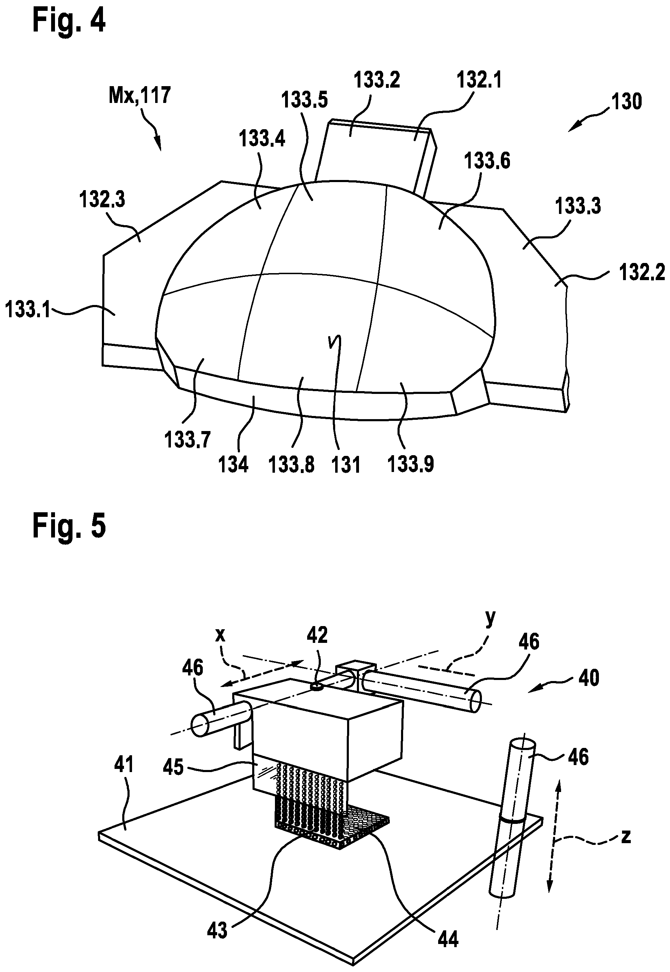

Figur 4 zeigt ein erfindungsgemäßes als Spiegel Mx, 117 ausgebildetes optisches Element mit einem Grundkörper 130, welcher drei Anbindungen 132.1, 132.2, 132.3 und einen optischen Bereich 134, welcher die optische Wirkfläche 131 umfasst, aufweist. Weiterhin umfasst der Grundkörper 130 Materialzonen 133.1-133.9, welche zumindest teilweise gemäß dem nachfolgend beschriebenen Herstellverfahren erhalten wurden. Diese unterscheiden sich durch die Zusammensetzung eines bei der Herstellung in den Materialzonen 133.1-133.9 verwendeten Strukturmaterials, wobei Strukturmaterialien mit unterschiedlichen Zusammensetzungen über das nachfolgend beschriebene Herstellverfahren gemischt werden können und somit eine beliebige Verteilung von Titanoxid im Grundkörper 130 hergestellt werden kann. Die Titanoxidkonzentration im Grundkörper bestimmt die Nulldurchgangstemperatur, also diejenige Temperatur, bei welcher der Wärmeausdehnungskoeffizient des entsprechenden Bereiches des Grundkörpers gleich null ist. Durch das erfindungsgemäße Verfahren kann die Nulldurchgangstemperatur über den Grundkörper 130 hinweg einer im Betrieb der zugehörigen Projektionsbelichtungsanlage vorherrschenden Temperaturverteilung angepasst werden. Dies hat den Vorteil, dass der Grundkörper 130 auch im Falle des Auftretens von Temperaturgradienten über ihn hinweg bei einem Wärmeausdehnungskoeffizienten von null betrieben werden kann, so dass Abweichungen von der Solltemperatur keine oder nahezu keine Deformationen auf einer auf dem Grundkörper 130 ausgebildeten optischen Wirkfläche 131 bewirken. Eine Temperaturschwankung des Grundkörpers 130 hat also keine Auswirkungen mehr auf die Abbildungsqualität der in der Figur 1 und der Figur 2 erläuterten Projektionsbelichtungsanlage 1, 101.

Figur 5 zeigt einen im erfindungsgemäßen Verfahren zur Herstellung des optischen Elementes verwendeten 3D-Drucker 40. Dieser umfasst einen Objekttisch 41, auf welchem die Struktur des optischen Elementes gedruckt wird. Der Objekttisch 41 ist mit einer Führung 46 in z-Richtung verbunden, so dass der Abstand zwischen dem Objekttisch 41 und einem Druckkopf 42 des 3D-Druckers 40 eingestellt werden kann. Der Bewegungsbereich des Objekttisches 41 entlang der z-Achse entspricht der maximalen Dicke des optischen Elementes, welche durch das Drucken erreicht werden kann. Der Druckkopf 42 umfasst in der in der Figur 4 dargestellten Ausführungsform zwei Düsenarrays (nicht dargestellt), welche zwei unterschiedliche Materialgemische drucken. Die beiden Düsenarrays können derart angesteuert werden, dass die beiden Materialgemische zu jeder Zeit in einem beliebigen Mischungsverhältnis gemischt werden können, wodurch die Übergänge des Materials in der Struktur konstant oder abrupt sein können. Der Aufbau und das Verfahren sind mit einem Tintenstrahldrucker vergleichbar. Die Anzahl der Düsenarrays kann nahezu beliebig erweitert werden, so dass noch weitere Materialgemische verwendet werden können. Die zum Drucken verwendeten Materialgemische 43, 44 umfassen ein Trägermaterial und ein Strukturmaterial und sind flüssig und damit druckbar. Das Strukturmaterial ist ein aus Glas oder anderen sinterbaren Stoffen hergestelltes Pulver, typischerweise mit einer Korngröße von 50 µm bis 150 µm. Die verwendeten Stoffe zur Erstellung des Pulvers bestimmen dabei das Materialgemisch. Das Trägermaterial umfasst ein Monomer und/oder Oligomer und einen Fotoinitiator, welche üblicherweise Onium-Verbindungen umfassen, wie beispielsweise Aryldiazonium, Diaryliodonium oder Triarylsulfonium, wobei auch andere Fotoinitiatoren Anwendung finden können. Wie bereits erwähnt, bildet das Materialgemisch aus dem Trägermaterial und dem Strukturmaterial eine druckbare Flüssigkeit. Der Druckkopf 42 kann in der x-y-Ebene bewegt werden, so dass nahezu der gesamte Objekttisch 41 zum Drucken des optischen Elementes verwendet werden kann. Im Druckkopf 42 ist in Bewegungsrichtung hinter den Düsenarrays noch ein in Form eines Vorhangs ausgebildetes UV-Licht 45 angeordnet, welcher im gezeigten Beispiel die gleiche Breite wie die Düsenarrays aufweist. Die Materialgemische 43, 44 werden dadurch direkt nach dem Aufbringen durch das UV-Licht 45 polymerisiert, wodurch die Struktur schichtweise aufgebaut wird. Der Fotoinitiator löst durch die Aufnahme des Lichtes üblicherweise eine kationische Polymerisation aus und unterstützt und beschleunigt dadurch den Polymerisationsprozess vorteilhaft und wird dabei üblicherweise zerstört.

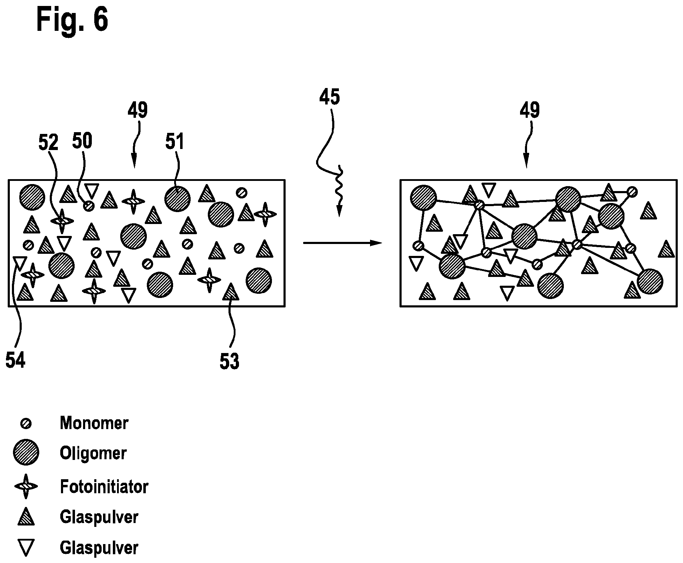

Figur 6 zeigt eine schematische Darstellung einer aus den Materialgemischen 43, 44 gedruckten Struktur 49 vor und nach der Polymerisation durch das UV-Licht 45. Die Materialgemische 43, 44 umfassen jeweils Monomere 50, Oligomere 51 und den in der Figur 4 bereits erläuterten Fotoinitiator 52 als Trägermaterial. In diesem Trägermaterial sind in den beiden Materialgemischen 43, 44 jeweils unterschiedliche Glaspulver 53, 54 enthalten, die sich erfindungsgemäß in ihrer Titankonzentration unterscheiden. Die Titankonzentration in der Struktur 49 bestimmt, wie weiter oben bereits erläutert, die Nulldurchgangstemperatur (Zero Crossing Temperatur), also die Temperatur, bei welcher der Wärmeausdehnungskoeffizient null ist. In der gedruckten Struktur 49 sind beide Glaspulver 53, 54 aus den beiden Materialgemischen 43, 44 vorhanden, wobei das Glaspulver 53 in der gesamten Struktur 49 verteilt ist und das Glaspulver 54 nur auf der linken Seite der Struktur 49 vorhanden ist. Dies soll die Möglichkeit einer beliebigen Kombination der beiden Materialgemische 43, 44 beim 3D-Druck verdeutlichen. Die rechte Seite der Figur 5 zeigt die Struktur nach der durch das UV-Licht 45 bewirkten Polymerisation von den Monomeren 50 und Oligomeren 51, welche zur Verdeutlichung der Vernetzung mit Linien untereinander verbunden sind. Die Fotoinitiatoren 52 sind durch das UV-Licht 45 zerstört und die Glaspulver 53, 54 sind in der gedruckten Position verblieben. Dieser Zustand wird als Grünling bezeichnet, welche ein mit Glaspulver 53, 54 gefüllter, formstabiler und fester Kunststoffkörper ist. Im weiteren Prozess zur Herstellung des optischen Elementes Mx, 117 wird der Grünling auf über 600° Celsius erhitzt. Bei 600° Celsius verbrennt der Kunststoff und die im Kunststoff verteilten Glaspulveranteile werden aneinander angesintert, verbinden sich also miteinander, so dass die Struktur ihre Form bei minimalem Schrumpf behält. Dieser sogenannte Braunling wird in einem Konvektionsofen oder Mikrowellenofen bei circa 1300° Celsius zu einem optischen Element gesintert. Der Schrumpf liegt je nach prozentualem Anteil des Glaspulvers 53, 54 im Materialgemisch 43, 44 bei 5% bis 20%, insbesondere zwischen 7% und 15,6%.

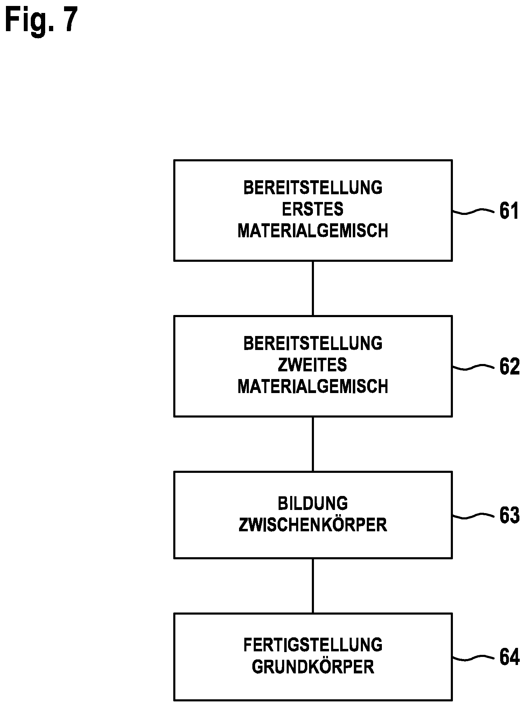

Figur 7 beschreibt ein Verfahren zur Herstellung eines Grundkörpers 30 für ein optisches Element Mx, 117.

In einem ersten Verfahrensschritt 61 wird ein erstes Materialgemisch, umfassend ein erstes Trägermaterial und ein erstes Strukturmaterial, bereitgestellt.

In einem zweiten Verfahrensschritt 62 wird ein zweites Materialgemisch, umfassend ein zweites Trägermaterial und ein zweites Strukturmaterial, bereitgestellt.

In einem dritten Verfahrensschritt 63 wird ein Zwischenkörper unter Zusammenführung der Materialgemische und Polymerisation der Trägermaterialien gebildet.

In einem vierten Verfahrensschritt 64 wird mindestens ein Teil des Grundkörpers durch Erwärmung des Zwischenkörpers zum thermischen Verbinden der Strukturmaterialien und zur Entfernung der Trägermaterialien hergestellt.

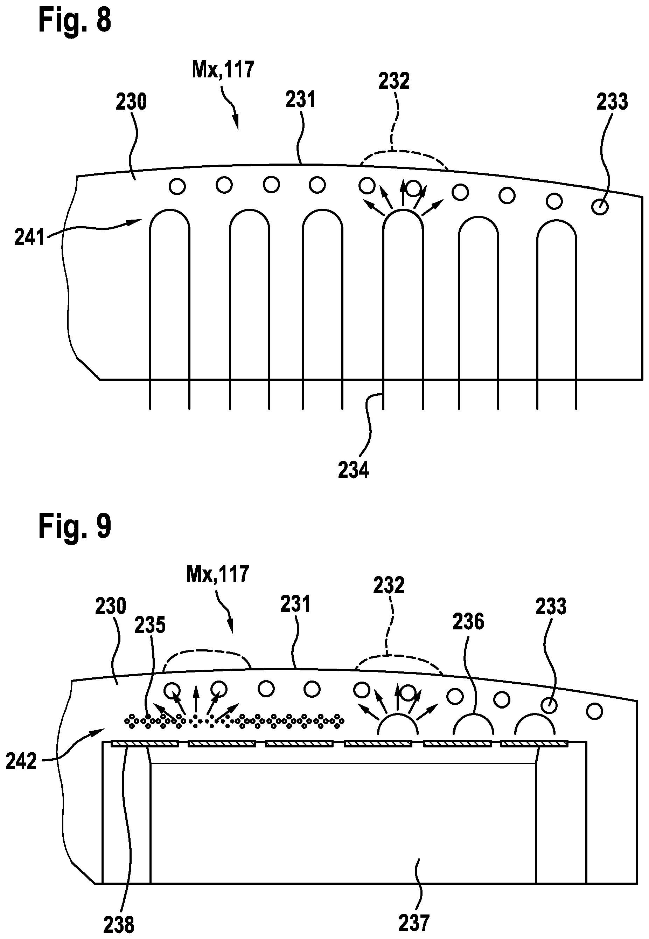

Figur 8 zeigt einen Grundkörper 230 für ein als Spiegel Mx, 117 ausgebildetes optisches Element, wie es in einer der in der Figur 1 und der Figur 2 erläuterten Projektionsbelichtungsanlagen eingesetzt werden kann, in einer ersten Ausführungsform der Erfindung. Der Spiegel Mx, 117 umfasst dabei den Grundkörper 230 mit einer optischen Wirkfläche 231. Im Grundkörper 230 sind unterhalb der optischen Wirkfläche 231 Kühlkanäle 233 ausgebildet, welche das optische Element Mx, 117 während des Betriebes beispielsweise während des Betriebs einer zugehörigen Projektionsbelichtungsanlage temperieren. Unterhalb der Kühlkanäle 233 sind als Heizdrähte 234 ausgebildete Aktuatorelemente im Grundkörper 230 angeordnet, welche in einem additiven Herstellverfahren des Grundkörpers 230, wie beispielsweise 3D-Druck oder Stereolithografie, integriert wurden. Die Heizdrähte 234 werden über eine in der Figur nicht dargestellte Ansteuerung mit elektrischem Strom beaufschlagt und wirken in ihrer Gesamtheit als ein Widerstandsaktuator 241. Durch den ohmschen Widerstand im Heizdraht 234 erwärmt sich der Grundkörper 230 bereichsweise, wodurch eine thermische Ausdehnung des erwärmten Bereichs bewirkt wird, welche sich bis zur optischen Wirkfläche 231 fortsetzt und dort zu einer Deformation führt. Durch eine gezielte Ansteuerung und Regelung der Temperaturverteilung in dem mit Heizdrähten 234 durchzogenen Bereich des Grundkörpers 230 kann mit dem Widerstandsaktuator 241 eine vorbestimmte Deformation 235 auf der optischen Wirkfläche 231 zur Korrektur von Abbildungsfehlern eingestellt werden. Die Kühlkanäle 233 dienen bei der Temperierung als Wärmesenke und schirmen eine parasitäre Wärmeleitung aus dem Grundkörper 230 in Richtung der optischen Wirkfläche 231 ab.

Figur 9 zeigt eine weitere Ausführungsform eines Grundkörpers 230 eines als Spiegel Mx, 117 ausgebildeten optischen Elements, welches wie das in der Figur 8 erläuterte optische Element Mx, 117 unter der optischen Wirkfläche 231 angeordnete Kühlkanäle 233 umfasst. Im Gegensatz zu dem in der Figur 3 dargestellten optischen Element sind an Stelle der Heizdrähte 234 elektrisch leitfähige Partikel 235 beziehungsweise elektrisch leitfähige Bauteile 236, wie beispielsweise Drähte oder Platten, in den Grundkörper 230 integriert. Im Fall einer Herstellung des Grundkörpers 230 mit einem 3D-Drucker nach dem Polyjet-Verfahren können die Partikel 235 in einer der mit dem 3D-Drucker gedruckten Materialmischungen an vorbestimmten Positionen des Grundkörper 230 gezielt mitgedruckt werden. Abhängig von dem Mischungsverhältnis der mindestens zwei im Polyjet-Verfahren verwendeten Materialmischungen kann dadurch die Konzentration der Partikel 235 gezielt eingestellt werden. Dadurch können einzelne Bereiche mit hoher Konzentration und Bereiche mit geringer Konzentration beziehungsweise ohne Partikel 235 im Grundkörper 230 ausgebildet werden.

Weiterhin können auch elektrisch leitfähige Bauteile 236 beim 3D-Druck mit dem Polyjet-Verfahren durch Einlegen der Bauteile 236 im Grundkörper 230 integriert werden. Alternativ können die Bauteile 236 auch mit anderen 3D-Druckverfahren, welche nur ein Materialgemisch verarbeiten können, wie beispielsweise der Stereolithografie, in den Grundkörper 230 integriert werden. In einer Ausnehmung 237 im Grundkörper 230 sind in der Nähe der Partikel 235 und der Bauteile 236 Induktionsspulen 238 angeordnet. Diese bewirken beim Anlegen eines Wechselstroms durch eine nicht dargestellte Ansteuerung, dass in die Partikel 235 und/oder Bauteile 236 elektrische Ströme induziert werden, wodurch sich diese aufgrund ihres Ohmschen Widerstandes erwärmen. Dadurch werden auch die benachbarten Bereiche im Grundkörper 230 erwärmt und eine vorbestimmte Deformation des Grundkörpers 230 und dadurch der optischen Wirkfläche 231 bewirkt.

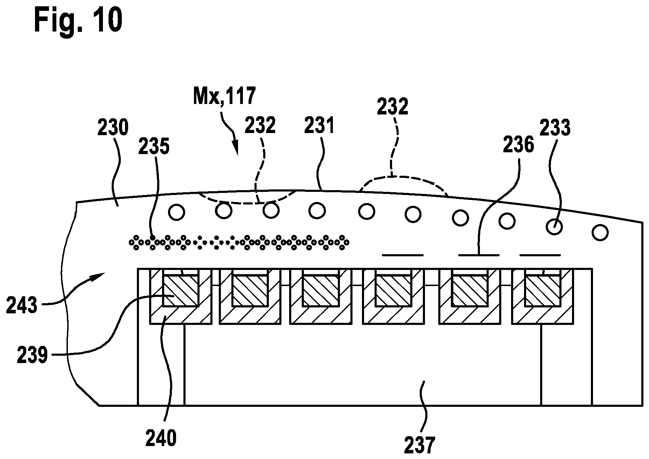

Figur 10 zeigt eine weitere Ausführungsform eines Grundkörpers 230 eines als Spiegel Mx, 117 ausgebildeten optischen Elements, welches wie das in der Figur 8 und der Figur 9 erläuterte optische Element Mx, 117 unter der optischen Wirkfläche 231 angeordnete Kühlkanäle 233 umfasst. Weiterhin umfasst der Grundkörper 230 auch die bereits in der Figur 9 dargestellten Partikel 235 und/oder Bauteile 236. An Stelle der Induktionsspulen 238 umfasst der Grundkörper 230 Elektromagnete 239, welche, wie die in der Figur 9 erläuterten Induktionsspulen 238, in unmittelbarer Nähe zu den Partikeln 235 und Bauteilen 236 in einer Ausnehmung 237 im Grundkörper 230 angeordnet sind. Die Elektromagnete 239 werden in einer an der Ausnehmung 237 ausgebildeten Aufnahme 240 aufgenommen und wirken mit den magnetisierbaren Partikeln 235 und Bauteilen 236 als elektromagnetischer Aktuator 243. Dieser kann, wie auch die weiter oben erläuterten Thermalaktuatoren 241, 242, eine vorbestimmte Deformation in der optischen Wirkfläche 231 zur Korrektur von Abbildungsfehlern erzeugen.

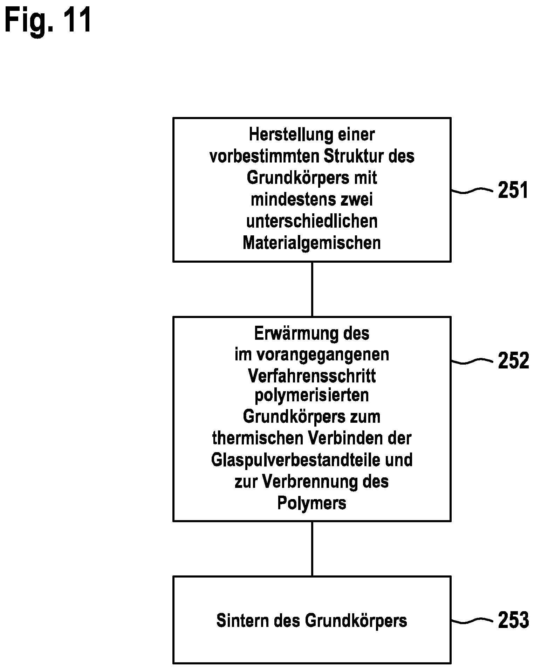

Figur 11 beschreibt ein Verfahren zur Herstellung eines Grundkörpers 230 für ein optisches Element Mx, 117.

In einem ersten Verfahrensschritt 251 wird eine vorbestimmte Struktur des Grundkörpers 230 mit mindestens zwei unterschiedlichen Materialgemischen hergestellt, wobei die Materialgemische ein Trägermaterial mit mindestens einem Monomer und/oder Oligomer und ein Strukturmaterial mit mindestens einem Glaspulver aufweisen und sich die Materialgemische mindestens durch zwei unterschiedliche Glaspulver im Strukturmaterial unterscheiden.

In einem zweiten Verfahrensschritt 252 wird der im vorherigen Verfahrensschritt 251 polymerisierte Grundkörpers 230 zum thermischen Verbinden der Glaspulverbestandteile und zur Verbrennung des Polymers erwärmt.

In einem dritten Verfahrensschritt 253 wird der Grundkörper 230 gesintert.

Die in den Figuren 8 bis 10 dargestellten Aktuatorelemente 234, 235, 236, 238, 239 und Aktuatoren 241, 242, 243 bewirken durch eine Erwärmung bestimmter Bereiche des Grundkörpers 230 oder durch magnetische Kraft eine Deformation des Grundkörpers 230, welche sich bis auf die optische Wirkfläche 231 fortpflanzt. Dieser Effekt wird bei den Thermalaktuatoren 241, 242 durch einen hohen Wärmeausdehnungskoeffizienten im Bereich der integrierten Aktuatorelemente 234, 235, 236 verstärkt. In Kombination mit einem geringen Wärmeausdehnungskoeffizienten, also einer Nulldurchgangstemperatur von null oder nahezu null, im Bereich der optischen Wirkfläche 231 des Grundkörpers 230 werden die vorbestimmte Deformation durch die Aktuatoren 241, 242, 243 maximiert und die parasitäre Deformation durch Absorption von auf die optische Wirkfläche auftreffenden elektromagnetischer Strahlung minimiert. Der Wärmeausdehnungskoeffizient beziehungsweise die Nulldurchgangstemperatur kann durch das in der Figur 11 beschriebene Herstellungsverfahren in beliebiger Weise über den Grundkörper 230 variiert werden. Der Grundkörper 230 kann alternativ auch für einen Messaufbau oder einen Objekttisch einer Koordinatenmessmaschine und jeder anderen Anwendung Verwendung finden, welche eine Fläche mit einer hohen Temperaturstabilität und/oder eine hochgenaue Oberfläche erfordert.

### Bezugszeichenliste

- 1: Projektionsbelichtungsanlage
- 2: Beleuchtungssystem
- 3: Strahlungsquelle
- 4: Beleuchtungsoptik
- 5: Objektfeld
- 6: Objektebene
- 7: Retikel
- 8: Retikelhalter
- 9: Retikelverlagerungsantrieb
- 10: Projektionsoptik
- 11: Bildfeld
- 12: Bildebene
- 13: Wafer
- 14: Waferhalter
- 15: Waferverlagerungsantrieb
- 16: EUV-Strahlung
- 17: Kollektor
- 18: Zwischenfokusebene
- 19: Umlenkspiegel
- 20: Facettenspiegel
- 21: Facetten
- 22: Facettenspiegel
- 23: Facetten
- 31: Erster Verfahrensschritt
- 32: Zweiter Verfahrensschritt
- 33: Dritter Verfahrensschritt
- 30: Grundkörper
- 131: optische Wirkfläche
- 132: Anbindung
- 133: Materialzonen
- 34: optischer Bereich
- 40: 3D-Drucker
- 41: Objekttisch
- 42: Druckkopf
- 43: Materialgemisch A
- 44: Materialgemisch B
- 45: UV-Licht
- 46: Führung X-Achse
- 47: Führung Y-Achse
- 48: Führung Z-Achse
- 49: Struktur
- 50: Monomer
- 51: Oligomer
- 52: Fotoinitiator
- 53: Glaspulver A
- 54: Glaspulver B
- 61: Verfahrensschritt 1
- 62: Verfahrensschritt 2
- 63: Verfahrensschritt 3
- 64: Verfahrensschritt 4
- 101: Projektionsbelichtungsanlage
- 102: Beleuchtungssystem
- 107: Retikel
- 108: Retikelhalter
- 110: Projektionsoptik
- 113: Wafer
- 114: Waferhalter
- 116: DUV-Strahlung
- 117: optisches Element
- 118: Fassungen
- 119: Objektivgehäuse
- M1-M6: Spiegel
- 130: Grundkörper
- 134: Optischer Bereich
- 230: Grundkörper
- 231: optische Wirkfläche
- 232: Deformation
- 233: Kühlkanäle
- 234: Heizdraht
- 235: Partikel
- 236: Bauteil
- 237: Ausnehmung
- 238: Induktionsspule
- 239: Elektromagnet
- 240: Aufnahme für Elektromagnet
- 241: Widerstandsaktuator
- 242: Induktionsaktuator
- 243: Elektromagnetischer Aktuator
- 251: Verfahrensschritt 1
- 252: Verfahrensschritt 2
- 253: Verfahrensschritt 3

## Patentansprüche

1. Verfahren zur Herstellung eines Grundkörpers eines optischen Elementes (Mx, 117) für die Halbleiterlithografie,
wobei
es sich um ein additives Verfahren handelt, welches folgende Verfahrensschritte umfasst:
- Bereitstellen eines ersten Materialgemisches (43), umfassend ein erstes Trägermaterial und ein erstes Strukturmaterial
- Bereitstellen eines zweiten Materialgemisches (44), umfassend ein zweites Trägermaterial und ein zweites Strukturmaterial
- wobei die Trägermaterialien mindestens ein Monomer (50) und/oder mindestens ein Oligomer (51) umfassen und wobei die Strukturmaterialien sich hinsichtlich ihrer Zusammensetzung unterscheiden
- Bildung eines Zwischenkörpers unter Zusammenführung der Materialgemische (43,44) und Polymerisation der Trägermaterialien
- Fertigstellung mindestens eines Teils des Grundkörpers (30) durch Erwärmung des Zwischenkörpers zum thermischen Verbinden der Strukturmaterialien und zur Entfernung der Trägermaterialien.

2. Verfahren nach Anspruch 2,
**dadurch gekennzeichnet, dass**
die Bildung eines Zwischenkörpers unter Verwendung eines Polyjet-Druckverfahrens erfolgt.

3. Verfahren nach Anspruch 1 oder 2,
**dadurch gekennzeichnet, dass**
mindestens eines der Strukturmaterialien ein Glaspulver (53,54) enthält.

4. Verfahren nach einem der Ansprüche 1 bis 3,
**dadurch gekennzeichnet, dass**
mindestens eines der Strukturmaterialien einen Zusatzstoff enthält.

5. Verfahren nach Anspruch 4,
**dadurch gekennzeichnet, dass**
sich die Strukturmaterialien hinsichtlich der Art der Zusatzstoffe unterscheiden.

6. Verfahren nach einem der Ansprüche 4 oder 5,
**dadurch gekennzeichnet, dass**
sich die Strukturmaterialien hinsichtlich der Konzentration der Zusatzstoffe unterscheiden.

7. Verfahren nach einem der Ansprüche 4 bis 6,
**dadurch gekennzeichnet, dass**
die Zusatzstoffe folgende Stoffe bzw. Stoffverbindungen umfassen: Titan, Titanoxid, Lithium, Aluminium, OH-Verbindungen.

8. Verfahren nach einem der Ansprüche 4 bis 7,
**dadurch gekennzeichnet, dass**
die Konzentration der Zusatzstoffe über den Grundkörper (30) zu einer bei einer Nutzung des optischen Elementes (117) ausgebildeten Temperaturverteilung im Grundkörper (30) korrespondiert.

9. Verfahren nach einem der Ansprüche 4 bis 8,
**dadurch gekennzeichnet, dass**
die Konzentration der Zusatzstoffe mit zunehmendem Abstand von einer für eine optische Wirkfläche (131) vorgesehenen Seite des Grundkörpers (30) abnimmt.

10. Verfahren nach Anspruch 9,
**dadurch gekennzeichnet, dass**
die Konzentration der Zusatzstoffe mit zunehmendem Abstand von einer für eine optische Wirkfläche (131) vorgesehenen Seite des Grundkörpers (30) bis zu einer gekühlten Schicht im Grundkörper (30) konstant abnimmt.

11. Verfahren nach einem der Ansprüche 1 bis 10,
**dadurch gekennzeichnet, dass**
das Verfahren zur Herstellung eines optischen Elementes (Mx, 117) für eine Projektionsbelichtungsanlage (1, 101) für die Halbleiterlithografie verwendet wird.

12. Grundkörper (30) für ein optisches Element (Mx, 117), wobei der Grundkörper (30) mindestens teilweise mittels eines additiven Verfahrens hergestellt ist, wobei sich die Nulldurchgangstemperatur des thermischen Längenausdehnungskoeffizienten mindestens in einem Teilbereich des Grundkörpers (30) ändert,
**dadurch gekennzeichnet, dass**
die Änderung der Nulldurchgangstemperatur in dem Teilbereich des Grundkörpers (30) stetig ist.

13. Grundkörper nach Anspruch 12,
**dadurch gekennzeichnet,**
**dass** die Änderung der Nulldurchgangstemperatur in einem Bereich von 20° Celsius bis 65° Celsius bei mehr als 1 K/mm liegt.

14. Grundkörper (30) nach einem der vorangehenden Ansprüche 12 oder 13,
**dadurch gekennzeichnet, dass**
die über den Grundkörper (30) zumindest teilweise variierende Nulldurchgangstemperatur zu einer bei einer Nutzung des optischen Elementes (117) ausgebildeten Temperaturverteilung im Grundkörper (30) korrespondiert.

15. Grundkörper (230) für ein optisches Element (Mx, 117), wobei der Grundkörper (230) mindestens einen Aktuator (241,242,243) und/oder Sensor umfasst, **dadurch gekennzeichnet, dass**
mindestens in einer additiv gefertigten Teilstruktur des Grundkörpers (230) mindestens eine Aktuatorkomponente (234,235,236) des Aktuators (241,242,243) und/oder eine Sensorkomponente (234,235,236) des Sensors integriert ist.

16. Grundkörper (230) nach Anspruch 15,
**dadurch gekennzeichnet, dass**
es sich bei der Aktuatorkomponente (234,235,236) und/oder der Sensorkomponente (234,235,236) um ein elektrisch leitfähiges Element (234,235,236) handelt.

17. Grundkörper (230) nach Anspruch 16,
**dadurch gekennzeichnet, dass**
die Aktuatorkomponente (234,235,236) und/oder die Sensorkomponente (234,235,236) mindestens einen Heizdraht (234) umfasst.

18. Grundkörper (230) nach Anspruch 16 oder 17,
**dadurch gekennzeichnet, dass**
die Aktuatorkomponente (234,235,236) und/oder die Sensorkomponente (234,235,236) elektrisch leitfähige Partikel (235) umfasst.

19. Grundkörper (230) nach einem der Ansprüche 16 bis 18,
**dadurch gekennzeichnet, dass**
die Aktuatorkomponente (234,235,236) und/oder die Sensorkomponente (234,235,236) elektrisch leitfähige Bauteile (236) umfasst.

20. Grundkörper (230) nach einem der vorangehenden Ansprüche 15 bis 19, **dadurch gekennzeichnet, dass**
die Aktuatorkomponente (234,235,236) und/oder die Sensorkomponente magnetisierbare Elemente (235,236) umfasst.

21. Grundkörper (230) nach einem der vorangehenden Ansprüche 15 bis 20
**dadurch gekennzeichnet, dass**
die Aktuatorkomponente (234,235,236) und/oder die Sensorkomponente (234,235,236) ein wärmeleitendes Element umfasst.

22. Projektionsbelichtungsanlage (1,101) für die Halbleiterlithographie,
**dadurch gekennzeichnet, dass**
sie ein optisches Element (Mx,117) mit einem Grundkörper nach einem der Ansprüche 12 bis 21 umfasst.

23. Projektionsbelichtungsanlage (1,101) für die Halbleiterlithographie nach Anspruch 22,
**dadurch gekennzeichnet, dass**
der Grundkörper des optischen Elementes (Mx,117) schichtweise aufgebaut ist und innerhalb des Grundkörpers Inhomogenitäten von Materialeigenschaften vorhanden sind, wobei das optische Element derart in der Projektionsbelichtungsanlage (1,101) angeordnet ist, dass die Richtung der größten Inhomogenitäten im Wesentlichen senkrecht zu einer Scanrichtung der Projektionsbelichtungsanlage (1,101) verläuft.

## Claims

1. Method for producing a main body of an optical element (Mx, 117) for semiconductor lithography, wherein
it is an additive method which comprises the following method steps:
- providing a first material mixture (43) comprising a first carrier material and a first structural material,
- providing a second material mixture (44) comprising a second carrier material and a second structural material,
- wherein the carrier materials comprise at least one monomer (50) and/or at least one oligomer (51) and wherein the structural materials differ in terms of their composition,
- forming an intermediate body by merging the material mixtures (43, 44) and polymerizing the carrier materials,
- finishing at least one part of the main body (30) by heating the intermediate body to thermally bond the structural materials and to remove the carrier materials.

2. Method according to Claim 2,
**characterized in that**
the formation of an intermediate body is performed using a polyjet printing method.

3. Method according to Claim 1 or 2,
**characterized in that**
at least one of the structural materials contains a glass powder (53, 54).

4. Method according to one of Claims 1 to 3, **characterized in that**
at least one of the structural materials contains an additive.

5. Method according to Claim 4,
**characterized in that**
the structural materials differ in terms of the type of the additives.

6. Method according to either of Claims 4 and 5, **characterized in that**
the structural materials differ in terms of the concentration of the additives.

7. Method according to one of Claims 4 to 6, **characterized in that**
the additives comprise the following substances or compounds: titanium, titanium oxide, lithium, aluminum, OH compounds.

8. Method according to one of Claims 4 to 7, **characterized in that**
the concentration of the additives over the main body (30) corresponds to a temperature distribution, established during use of the optical element (117), in the main body (30).

9. Method according to one of Claims 4 to 8, **characterized in that**
the concentration of the additives decreases as the distance from a side of the main body (30) that is intended for an optical surface (131) increases.

10. Method according to Claim 9,
**characterized in that**
the concentration of the additives constantly decreases as the distance from a side of the main body (30) that is intended for an optical surface (131) to a cooled layer in the main body (30) increases.

11. Method according to one of Claims 1 to 10, **characterized in that**
the method is used to produce an optical element (Mx, 117) for a projection exposure apparatus (1, 101) for semiconductor lithography.

12. Main body (30) for an optical element (Mx, 117), the main body (30) being produced at least partially by an additive method,
the zero-crossing temperature of the coefficient of linear thermal expansion changing at least in a partial region of the main body (30),
**characterized in that**
the change in the zero-crossing temperature is continuous in the partial region of the main body (30).

13. Main body according to Claim 12,
**characterized**
**in that** the change in the zero-crossing temperature ranges from 20° Celsius to 65° Celsius at more than 1 K/mm.

14. Main body (30) according to either of the preceding Claims 12 and 13,
**characterized in that**
the zero-crossing temperature which varies at least partially over the main body (30) corresponds to a temperature distribution, established during use of the optical element (117), in the main body (30).

15. Main body (230) for an optical element (Mx, 117), the main body (230) comprising at least one actuator (241, 242, 243) and/or sensor,
**characterized in that**
at least one actuator component (234, 235, 236) of the actuator (241, 242, 243) and/or one sensor component (234, 235, 236) of the sensor is integrated at least in an additively manufactured partial structure of the main body (230).

16. Main body (230) according to Claim 15,
**characterized in that**
the actuator component (234, 235, 236) and/or the sensor component (234, 235, 236) is an electrically conductive element (234, 235, 236).

17. Main body (230) according to Claim 16,
**characterized in that**
the actuator component (234, 235, 236) and/or the sensor component (234, 235, 236) comprises at least one heating wire (234).

18. Main body (230) according to Claim 16 or 17,
**characterized in that**
the actuator component (234, 235, 236) and/or the sensor component (234, 235, 236) comprises electrically conductive particles (235).

19. Main body (230) according to one of Claims 16 to 18, **characterized in that**
the actuator component (234, 235, 236) and/or the sensor component (234, 235, 236) comprises electrically conductive component parts (236).

20. Main body (230) according to one of the preceding Claims 15 to 19,
**characterized in that**
the actuator component (234, 235, 236) and/or the sensor component comprises magnetizable elements (235, 236).

21. Main body (230) according to one of the preceding Claims 15 to 20,
**characterized in that**
the actuator component (234, 235, 236) and/or the sensor component (234, 235, 236) comprises a thermally conductive element.

22. Projection exposure apparatus (1, 101) for semiconductor lithography,
**characterized in that**
it comprises an optical element (Mx, 117) having a main body according to one of Claims 12 to 21.

23. Projection exposure apparatus (1, 101) for semiconductor lithography according to Claim 22, **characterized in that**
the main body of the optical element (Mx, 117) is built up layer by layer and within the main body there are material property inhomogeneities, the optical element being arranged in the projection exposure apparatus (1, 101) in such a way that the direction of the greatest inhomogeneities runs substantially perpendicularly in relation to a scanning direction of the projection exposure apparatus (1, 101).

## Revendications

1. Procédé de fabrication d'un corps de base d'un élément optique (Mx,117) pour la lithographie des semiconducteurs,
le procédé étant un procédé additif qui comprend les étapes suivantes :
- fourniture d'un premier mélange de matériaux (43), comprenant un premier matériau support et un premier matériau structurel
- fourniture d'un deuxième mélange de matériaux (44), comprenant un deuxième matériau support et un deuxième matériau structurel
- les matériaux supports comprenant au moins un monomère (50) et/ou au moins un oligomère (51) et les matériaux structurels se différenciant du point de vue de leur composition
- formation d'un corps intermédiaire par regroupement des mélanges de matériaux (43, 44) et polymérisation des matériaux supports
- achèvement d'au moins une partie du corps de base (30) en chauffant le corps intermédiaire pour la connexion thermique des matériaux structurels et l'élimination des matériaux supports.

2. Procédé selon la revendication 2,
**caractérisé en ce que**
la formation d'un corps intermédiaire est effectuée à l'aide d'un procédé d'impression polyjet.

3. Procédé selon la revendication 1 ou 2,
**caractérisé en ce que**
au moins l'un des matériaux structurels contient une poudre de verre (53, 54).

4. Procédé selon l'une des revendications 1 à 3, **caractérisé en ce que**
au moins l'un des matériaux structurels contient un additif.

5. Procédé selon la revendication 4,
**caractérisé en ce que**
les matériaux structurels se différencient du point de vue de la nature de l'additif.

6. Procédé selon l'une des revendications 4 ou 5, **caractérisé en ce que**
les matériaux structurels se différencient du point de vue de la concentration des additifs.

7. Procédé selon l'une des revendications 4 à 6, **caractérisé en ce que**
les additifs comprennent les substances ou composés suivants : titane, oxyde de titane, lithium, aluminium, composés OH.

8. Procédé selon l'une des revendications 4 à 7, **caractérisé en ce que**
la concentration des additifs dans le corps de base (30) correspond à une répartition de la température dans le corps de base (30) qui se forme lors de l'utilisation de l'élément optique (117).

9. Procédé selon l'une des revendications 4 à 8, **caractérisé en ce que**
la concentration des additifs diminue à mesure que la distance d'un côté du corps de base (30) prévu pour une surface active optique (131) augmente.

10. Procédé selon la revendication 9,
**caractérisé en ce que**
la concentration des additifs diminue de manière constante jusqu'à une couche refroidie dans le corps de base (30) à mesure que la distance d'un côté du corps de base (30) prévu pour une surface optique active (131) augmente.

11. Procédé selon l'une des revendications 1 à 10, **caractérisé en ce que**
le procédé est utilisé pour la fabrication d'un élément optique (Mx,117) pour une installation d'exposition par projection (1, 101) pour la lithographie des semiconducteurs.

12. Corps de base (30) pour un élément optique (Mx,117), le corps de base (30) étant fabriqué au moins partiellement au moyen d'un procédé additif,
la température de passage par zéro du coefficient de dilatation thermique linéaire variant au moins dans une zone partielle du corps de base (30) ;
**caractérisé en ce que**
la variation de la température de passage par zéro dans la zone partielle du corps de base (30) est constante.

13. Corps de base selon la revendication 12, **caractérisé en ce**
**que** la variation de la température de passage par zéro dans une plage de 20° Celsius à 65° Celsius est supérieure à 1 K/mm.

14. Corps de base (30) selon l'une des revendications 12 ou 13,
**caractérisé en ce que**
la température de passage pas zéro qui varie au moins partiellement sur le corps de base (30) correspond à une répartition de la température dans le corps de base (30) formée lors de l'utilisation de l'élément optique (117).

15. Corps de base (230) pour un élément optique (Mx,117), le corps de base (230) comprenant au moins un actionneur (241, 242, 243) et/ou un capteur, **caractérisé en ce que**
au moins un composant d'actionneur (234, 235, 236) de l'actionneur (241, 242, 243) et/ou un composant de capteur (234, 235, 236) du capteur est intégré au moins dans une structure partielle fabriquée de manière additive du corps de base (230).

16. Corps de base (230) selon la revendication 15, **caractérisé en ce que**
le composant d'actionneur (234, 235, 236) et/ou le composant de capteur (234, 235, 236) est un élément électriquement conducteur (234, 235, 236).

17. Corps de base (230) selon la revendication 16, **caractérisé en ce que**
le composant d'actionneur (234, 235, 236) et/ou le composant de capteur (234, 235, 236) comprend au moins un fil chauffant (234).

18. Corps de base (230) selon la revendication 16 ou 17, **caractérisé en ce que**
le composant d'actionneur (234, 235, 236) et/ou le composant de capteur (234, 235, 236) comprend des particules électriquement conductrices (235).

19. Corps de base (230) selon l'une des revendications 16 à 18,
**caractérisé en ce que**
le composant d'actionneur (234, 235, 236) et/ou le composant de capteur (234, 235, 236) comprend des éléments constitutifs électriquement conducteurs (236).

20. Corps de base (230) selon l'une des revendications 15 à 19 précédentes,
**caractérisé en ce que**
le composant d'actionneur (234, 235, 236) et/ou le composant de capteur comprend des éléments magnétisables (235, 236).

21. Corps de base (230) selon l'une des revendications 15 à 20 précédentes,
**caractérisé en ce que**
le composant d'actionneur (234, 235, 236) et/ou le composant de capteur (234, 235, 236) comprend un élément conducteur de chaleur.

22. Système d'exposition par projection (1, 101) pour la lithographie des semiconducteurs,
**caractérisé en ce que**
il comprend un élément optique (Mx,117) avec un corps de base selon l'une des revendications 12 à 21.

23. Système d'exposition par projection (1,101) pour la lithographie des semiconducteurs selon la revendication 22,
**caractérisé en ce que**
le corps de base de l'élément optique (Mx,117) est constitué de couches et des hétérogénéités des propriétés du matériau sont présentes à l'intérieur du corps de base, l'élément optique étant disposé dans le système d'exposition par projection (1,101) de telle sorte que la direction des hétérogénéités les plus importantes s'étende sensiblement perpendiculairement à une direction de balayage du système d'exposition par projection (1,101).
